# EUROPEAN PATENT SPECIFICATION

(11) **EP 0 421 433 B1**
(45) Date of publication and mention of the grant of the patent: **22.01.1997**
(21) Application number: 90119070.2
(22) Date of filing: 04.10.1990
(51) Int. Cl.: H04N 9/04

(54) **Signal processing circuit for solid-state imaging apparatus**
Signalverarbeitungsschaltung für Festkörper-Bildaufnahmevorrichtung
Circuit de traitement de signaux pour dispositif de prise d'images à l'état solide

(30) Priority: 04.10.1989 JP 257923/89; 21.11.1989 JP 302762/89
(43) Date of publication of application: 10.04.1991
(73) Proprietor: SONY CORPORATION, Tokyo (JP)
(72) Inventor: Asaida, Takashi, Shinagawa-ku, Tokyo (JP)
(74) Representative: TER MEER - MÜLLER - STEINMEISTER & PARTNER

(56) References cited:
- EP-A- 0 068 811
- EP-A- 0 368 354

## Description

### Field of the Invention

This invention relates to an apparatus in which the imaging section is arranged with a spatial pixel shifting or offsetting in which the solid state image sensors for green and red color imaging are arranged with a spatial offset of one half the pixel repetition pitch in accordance with the precharacterizing part of claim 1. Such an image processing apparatus is known from EP-A-0 368 354 which represents prior art according to Article 54(3) EPC.

### Prior Art

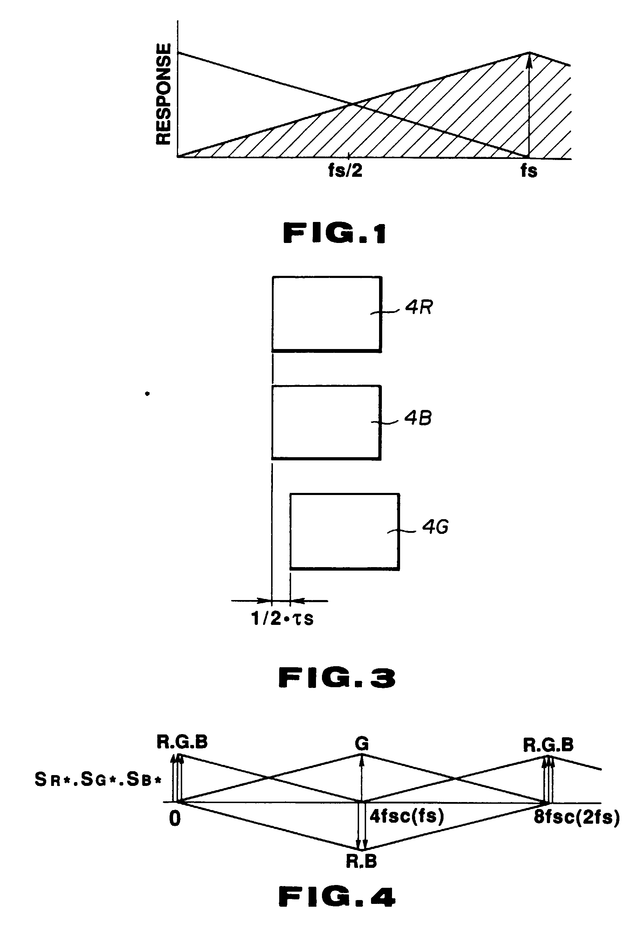

In a solid state imaging apparatus in which the imaging section is constituted by a solid-state image sensor having a discrete pixel structure formed by charge coupled devices (CCDs), since the solid state image sensor itself is of the sampling system, aliasing components from the spatial sampling frequency fs are mixed into imaging output signals from the solid state image sensor, as shown by hatched line in Fig. 1.

The conventional practice for preventing aliasing components from being mixed into the baseband of the imaging signals is to suppress the high frequency side of the baseband components of the imaging signal to satisfy the Nyquist conditions of the sampling system by the solid state image sensor.

In a color television camera, a multi-CCD type solid-state imaging apparatus, such as a two CCD type imaging apparatus in which a three-color image is formed by a solid-state image sensor provided with a solid-state image sensor for forming a green color image and a color coding filter for each of the red and blue pixels, or a three CCD type solid-state image forming apparatus in which the three-color image is formed by separate solid-state image sensors, are put to practical use.

In addition, as a technique for improving the resolution in the above mentioned multi-CCD type solid-state image sensor, there is known a so-called pixel shifting or offsetting technique in which the solid-state image sensors for forming red and blue color images are offset with respect to the solid-state image sensor for forming a green color image by one half the spatial pixel sampling period. With the use of the spatial offsetting technique, a high resolution beyond the limit of the number of pixels in the solid-state image sensor may be realized with the analog output multi-CCD type solid-state imaging apparatus.

In business digital video tape recorder, used in a broadcasting station or the like, standards for the so called D1/D2 format are being prepared, and a digital interface for digital video related equipment meeting such standards has been necessary in a color television camera. In a standard for digital interface for digital video related equipment, the sampling rate is set to about equal to the sampling rate fs of the presently availabe solid-state image sensor. EP-A-0 368 354 representing prior art according to Article 54(3) EPC and corresponding to the precharacterizing part of claim 1 describes a signal-processing circuit including an image enhancement section which comprises in series connection a first and a second lH-delay circuit and an image enhancement data forming circuit. The image enhancement data forming circuit is directly supplied with green color data from the A/D converter for the green color image signal. Further, the image enhancement data forming circuit is supplied with one lH-delayed green color data and 2H-delayed green color data and further with non-delayed red color data from the A/D converter for the red color image signal. On the basis of these delayed and non-delayed signals the image enhancement data forming circuit forms image enhancement data having a clock rate 2 fs twice the clock-rate fs. This image enhancement data is supplied to first adders and to second adders, respectively provided in the signal path of the interpolated green color data, red color data, blue color data before and after gamma-correction circuits, respectively. The first adders provided upstream of the gamma-correction circuits sum the image enhancement data with the clock rate of 2 fs to the interpolated color data having the clock rate 2 fs and transmit the image enhancement color data to the corresponding gamma correction circuit. The gamma correction circuits perform gamma correction of the enhanced color data from the first adders and transmit the gamma-corrected color data to the second adders downstream of the gamma-correction circuits. The second adders are summing the image enhancement data supplied from the image enhancement section at the clock rate of 2 fs to the gamma-corrected color data from the gamma-correction circuit. Further, the gamma-corrected and enhanced color data having the clock rate 2 fs are respectively transmitted to a color encoder and digital/analog converters converting the high resolution color data supplied with the clock rate 2 fs into analog three-color image pick-up output signals.

### Object and Summary of the Invention

It is an object of the present invention to provide a signal processing circuit for a solid-state color camera provided with an imaging section constructed under the spatial offsetting technique in which a horizontal detail signal may be produced for optimum image enhancement of the various color image signals with the least risk of cross color interference.

The above object is solved in a signal processing circuit as described by the precharacterizing part of claim 1 according to the invention by its characterizing features.

Dependent claims 2 to 12 are each specifying advantageous developments thereof.

According to an advantageous feature of the present invention said signal processing circuit is adapted to eliminate aliasing components contained in the detail signal and to prevent the cross-color interference from being generated as a result of the mixing of the horizontal detail signals into the color subcarrier frequency region. According to a still further aspect of the present invention, gamma compensation or image enhancement may be performed satisfactorily without picture quality deterioration due to the aliasing components or cross-color interference.
According to the preferred signal processing circuit, output imaging signals read from the solid-state image sensor at the sampling rate equal to fs are subjected to image enhancement at the clock rate equal to 2 fs. Preferably, said digital output signals processed by image enhancement at the clock rate equal to 2 fs may be satisfactorily processed by gamma correction. It is a further embodiment of the present signal processing circuit to employ digital filters for interpolation and for producing the detail signal which are selected to have zero points at the frequency equal to fs and to have the same number of orders as to odd and even order numbers.

Further, the present signal processing circuit is adapted to provide optimum image enhancement coping with changes in the imaging environment.
Advantageously, the detail signal formed from the output imaging signal produced at the imaging section may be subjected to a non-linear arithmetic operation in which compression characteristics on the more positive and more negative level side with respect to a predetermined level may be set independently.
Further advantageously, the input signal may be clipped at a predetermined level by a non-linear arithmetic operation. The preferred signal processing circuit is adapted to produce the broad range detail signal free from aliasing components for the output imaging signal.
According to yet another aspect of the present invention, a signal-processing circuit for a solid-state imaging apparatus is provided in which the vertical detail signal is band-limited in the horizontal direction before being outputted to prevent the vertical detail signal component from being mixed into the region of the color subcarrier frequency.

### BRIEF DESCRIPTION OF THE DRAWINGS

Fig. 1 is a diagrammatic view showing the signal spectrum of an output imaging signal by a customary solid-state image sensor having a discrete pixel arrangement.

Fig. 2 is a block diagram showing a three CCD type color television camera to which the present invention is applied.

Fig. 3 is a diagrammatic view showing the arraying state of the CCD image sensors in the color television camera shown in Fig. 2.

Fig. 4 shows the signal spectrum for each output imaging signal from the associated CCD image sensor of the color television camera shown in Fig. 2.

Fig. 5 is a block diagram showing the arrangement of a signal processing section of the color television camera shown in Fig. 2.

Fig. 6 is a block diagram showing another embodiment of the signal processing section of the color television camera shown in Fig. 2.

Fig. 7 is a chart showing filtering characteristics of a digital filter provided in an interpolator of the signal processing section.

Fig. 8 is a chart showing filtering characteristics of a digital filter provided in a detail signal generator of the signal processing section.

Fig. 9 is a chart for illustrating the horizontal contour enhancement for the case in which the even number order interpolation is performed in the interpolating section and the odd number order interpolation is performed in the detail signal generator.

Fig. 10 is a chart for illustrating the horizontal contour enhancement operation for the case in which the even number order interpolation is performed in interpolator and the even number order differentiating operation is performed in the detail signal generator.

Fig. 11 is a chart for illustrating the horizontal contour enhancement operation for the case in which the even number order interpolation is performed in the interpolator and the odd number order differentiating operation is performed in the detail signal generator.

Fig. 12 is a block diagram showing a concrete example of the construction of the detail signal generator of the signal processing section.

Fig. 13 is a block diagram showing an equivalent block construction of a first digital filter circuit of the detail signal generator.

Fig. 14 is a chart showing filtering characteristics of the first digital filter circuit.

Fig. 15 is a diagrammatic view showing frequency characteristics of the detail signal formed in the detail signal generator.

Fig. 16 is a block diagram showing an equivalent block construction of a second digital filter circuit of the digital signal generator.

Fig. 17 is a chart showing filtering characteristics of the second digital filter circuit.

Fig. 18 is a block diagram showing another equivalent block construction of the second digital filter circuit of the detail signal generator.

Figs. 19A, 19B and 19C are block diagrams showing concrete constructions of first to third filter blocks in the second digital filter circuit shown in Fig. 18.

Figs. 20A, 20B, 20C and 20D are charts for illustrating the band-limiting operation of the second digital filter circuit shown in Fig. 18.

Fig. 21 is a block diagram showing a concrete block construction of a second core circuit of the detail signal generator shown in Fig. 12.

Fig. 22 is a chart showing characteristics of a non-linear operation of the second core circuit shown in Fig. 21.

Fig. 23 is a block diagram showing another block construction of the second core circuit of the detail signal generator shown in Fig. 12.

Fig. 24 is a chart showing characteristics of the non-linear operation of the second core circuit shown in Fig. 23.

Fig. 25 is a block diagram showing another embodiment of the detail signal generator of the signal processing section of the color television camera shown in Fig. 2.

Fig. 26 is a waveform diagram for illustrating the contour compensating operation of the detail signal generator shown in Fig. 25.

Fig. 27 is a block diagram showing the construction of a color encoder of the color television camera shown in Fig. 2.

### Embodiment

By referring to the drawings, a preferred illustrative embodiment of a signal processing circuit of a solid-state imaging apparatus according to the present invention will be explained in detail.

Fig. 2 shows a color television camera in which the present invention is applied to a three CCD solid-state imaging apparatus in which an imaging light Lᵢ incident from an imaging lens 1 by way of an optical low-pass filter 2 is separated by a color separating filter 3 into three prime color light components, that is a red (R), green (G) and blue (B) color light components, for imaging the three-color images of an object image on three CCD image sensors 4R, 4G and 4B.

In the present embodiment, the three CCD image sensors 4R, 4G and 4B constituting the imaging section of the color television camera are arrayed under the principle of spatial pixel offsetting so that the CCD image sensor 4R for forming the red color image and the CCD image sensor 4B for forming the blue color image are offset by one half the spatial sampling period τs with respect to the CCD image sensor 4G for forming the green color image. The three CCD image sensors 4R, 4G and 4B are driven by CCD driving circuits, not shown, so that the imaging charges of the pixels are read out by read-out clocks having a sampling frequency fs equal to four times the color sub-carrier frequency fsc, or 4 fsc.

Among the three CCD image sensors 4R, 4G and 4B, operating under the principle of spatial pixel offsetting, the CCD image sensor 4G for green color image on one hand and the CCD image sensors 4R and 4B for forming the red and blue color images on the other perform spatial sampling of the three color object images at positions offset by τs/2 from each other. In this manner, the imaging output signals S_{R*}, S_{G*} and S_{B*} are read out from the CCD image sensors 4R, 4G and 4B in such a manner that the sampling frequency component fs of the green imaging output signal S_{G*} by the CCD image sensor 4G is antiphase with respect to the sampling frequency components fs of the red color image output signal S_{R*} and the blue color image output signal S_{B*} by the CCD image sensors 4R and 4B, as shown in Fig. 4 showing signal spectral components.

The imaging output signals S_{R*}, S_{G*} and S_{B*}, read out from the CCD image sensors 4R, 4G and 4B by read-out clocks of the sampling frequency fs or 4 fsc, are supplied to analog/digital converters (A/D converters) 6R, 6G and 6B, respectively, by means of buffer amplifiers 5R, 5G and 5B.

To these A/D converters 6R, 6G and 6B are supplied clocks having a clock rate fs equal to the sampling rate of the image output signals S_{R*}, S_{G*} and S_{B*}, that is a clock frequency fs or 4 fsc equal to the read-out clocks of the CCD image sensors 4R, 4G and 4B. The A/D converters 6R, 6G and 6B directly digitize the imaging output signals S_{R*}, S_{G*} and S_{B*} at the clock rate fs or 4 fsc to form color data D_{R*}, D_{G*} and D_{B*} having the output spectrum that is the same as the spectrum of the imaging output signal S_{R*}, S_{G*} and S_{B*} shown in Fig. 4.

The color data D_{R*}, D_{G*} and D_{B*}, produced by the A/D converters 6R, 6G and 6B, are transmitted to a signal processor 7.

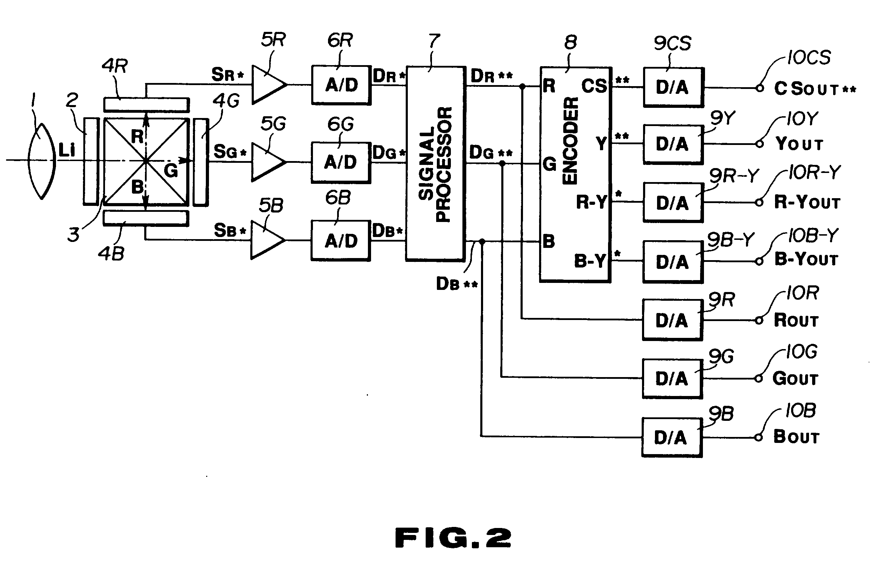

The signal processor 7 is constituted, as shown in Fig. 5 showing its concrete construction, by a detail signal generator 11 supplied with red color data D_{R*} from the A/D converter 6R and green color data D_{G*} from the A/D converter 6G, interpolators 13R, 13G and 13B supplied with three color data D_{R*}, D_{G*} and D_{B*} from the A/D converters 6R, 6G and 6B via delay circuits 12R, 12G and 12B, summing points or circuits 14R, 14G and 14B supplied with previously interpolated three color data D_{R**}, D_{G**} and D_{B*} from the interpolators 13R, 13G and 13B and with detail signal D_{IE**} from detail signal generator 11, and gamma correction circuits 15R, 15G and 15B supplied with a summation output from the summation points 14R, 14G and 14B.

The interpolators 13R, 13G and 13B of the signal processor 7 interpolate the three color data D_{R*}, D_{G*} and D_{B*} of the clock rate fs equal to 4 fsc from the A/D converters 6R, 6G and 6B to form the three color data D_{R**} D_{G**} and D_{B**} of the clock rate 2 fs equal to 8 fsc which is twice the clock rate fs. The interpolators 13R, 13G and 13B transmit the three color data D_{R**}, D_{G**} and D_{B**} of the clock rate equal to 2 fs to the summing points 14R, 14G and 14B.

The detail signal generator 11 is constituted by summing means for summing equal amounts of green color data D_{G*} of the fs rate from the A/D converter 6G and red color data D_{R*} of the fs rate from the A/D converter 6R after multiplexing at the clock rate 2 fs and a digital filter for differentiating an addition or summation output by the summing means. The detail signal generator 11 transmits a detail signal D_{IE**} containing a differential output by the digital filter to the summing points 14R, 14G and 14B.

These summing points 14R, 14G and 14B sum the detail signal D_{IE**} from the detail signal generator 11 to the three color data D_{R**}, D_{G**} and D_{B**} from the interpolators 13R, 13G and 13B for image enhancement of the three color data D_{R**}, D_{G**} and D_{B**}. The image enhanced three color data D_{R**}, D_{G**} and D_{B**} are supplied to the gamma correction circuits 15R, 15G and 15B, respectively.

The gamma correction circuits 15R, 15G and 15B operate at the clock rate 2 fs to process the image enhanced three color data D_{R**}, D_{G**} and D_{B**} by the summing circuit 14R, 14G and 14B by gamma correction to output gamma corrected color data D_{R**}, D_{G**} and D_{B**} at the 2 fs rate.

The color television camera the imaging section of which is constructed in accordance with the spatial offsetting technique, suffers from cross color interference due to aliasing components contained in the imaging output or mixing of the detail signal into the color subcarrier frequency region. However, the horizontal detail signal IEH of the 2 fs rate, which is formed by summing equal amounts of the green color data D_{G∗} of the fs rate from the A/D converter 6G and the red color data D_{R} of the fs rate from the A/D converter 6R after multiplexing at the clock rate 2 fs and differentiating the summation output, the first order carrier components are cancelled by the equal amount summation. Thus the broad range horizontal detail signal IEH free of aliasing distortion may be generated in the detail signal generator 11. Thus the summing circuits 14R, 14G and 14B sum the detail signal D_{IE**} containing the 2 fs rate horizontal detail signal IEH from the detail signal generator 11 to the 2 fs rate three color data D_{R**}, D_{G**} and D_{B**} from the interpolators 13R, 13G and 13B for processing the three color data D_{R**}, D_{G**} and D_{B**} by image enhancement of high resolution. The gamma correcting circuit 15R, 15G and 15B, to which the three color data D_{R**}, D_{G**} and D_{B**}, previously image enhanced by the summation circuits 14R, 14G and 14B, are transmitted, operate at the clock rate 2 fs for processing the three color data D_{R**}, D_{G**} and D_{B**} by image enhancement of high resolution.

Instead of summing equal amounts of the green color imaging signals and red color imaging signals, the detail signal generator 11 may sum equal amounts of the green color imaging signals and blue color imaging signals or sum equal amounts of a combined signal of the red and blue color image signals and the green color image signal, whereby the first order carrier components are cancelled to form the broad range horizontal detail signal free from aliasing distortions.

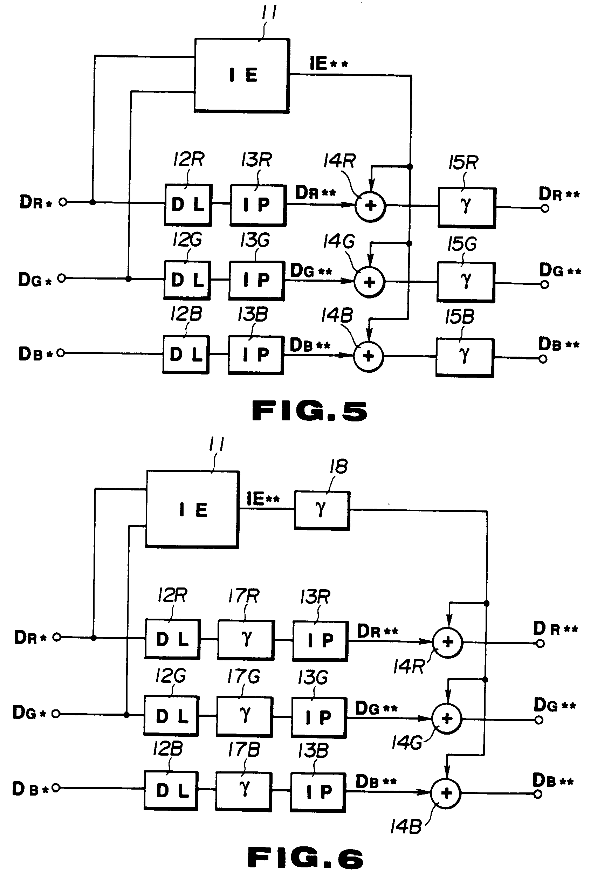

The signal processor 7 may also be provided, as shown in Fig. 6, with first gamma correction circuits 17R, 17G and 17B operating at the clock rate fs, upstream of the interpolators 13R, 13G and 13B, and a second gamma correction circuit 18 operating at a clock rate 2 fs, downstream of the detail signal generator 11.

The first gamma correction circuits 17R, 17G and 17B operate at the clock rate fs to process the fs-rate three-color data D_{R*}, D_{G*} and D_{B*} by gamma correction and to transmit the gamma corrected three-color data D_{R*}, D_{G*} and D_{B*} to the interpolators 13R, 13G and 13B. The interpolators 13R, 13G and 13B interpolate the gamma-corrected three-color data D_{R*}*, D_{G*} and D_{R*} from the first gamma correction circuits 17R, 17G and 17B to form the 2 fs rate three color data D_{R**}, D_{G**} and D_{B**}, which are supplied to the summation circuits 14R, 14G and 14B, respectively. The second gamma correction circuit 18 operates at the 2 fs clock rate to gamma correct the 2 fs rate detail signal D_{IE**}, outputted from the detail signal generator 11, while transmitting the gamma corrected detail signal D_{IE**} to the summation circuits 14R, 14G and 14B. The summing circuits 14R, 14G and 14B sum the gamma corrected 2 fs rate detail signal D_{IE**}, supplied from the detail signal generator 11 via second gamma correction circuit to the gamma corrected 2 fs rate three color signals D_{R**}, D_{G**} and D_{B**}, supplied from the first gamma correction circuits 17R, 17G and 17B via interpolators 13R, 13G and 13B, to perform an image enhancement operation.

The 2 fs rate three-color data D_{R**}, D_{G**} and D_{B**}, which have been gamma corrected and image enhanced with high resolution, may similarly be obtained by the above described signal processor 7.

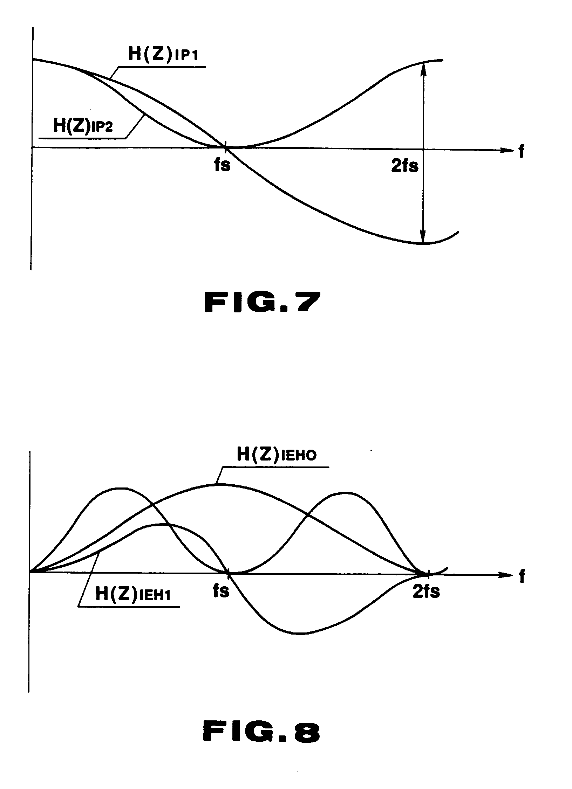

In the present embodiment, each of the interpolators 13R, 13G and 13B includes a digital filter operating on the fs-rate three-color data D_{R*}, D_{G*} and D_{B*} at a clock rate 2 fs or 8 fsc, which is twice the sampling frequency fs, and having filter characteristics H(z)_{IPM}${\text{H(z)}}_{\text{IPM}} {\text{= (z}}^{\text{-1}} {\text{+ 1)}}^{\text{m}}$ as shown in Fig. 7, having at least one zero point, Z being a unit delay of the 2 fs rate. In the detail signal generator 11, the digital filter differentiates the sum output from the summation means by providing the sum output by the summation means with filter characteristics H(z)_{IEHn} having, as shown in Fig. 8, at least one zero point at fs and the same number of orders n as to evenness or oddness as the number of orders m of the digital filters of the interpolators 13R, 13G and 13B.

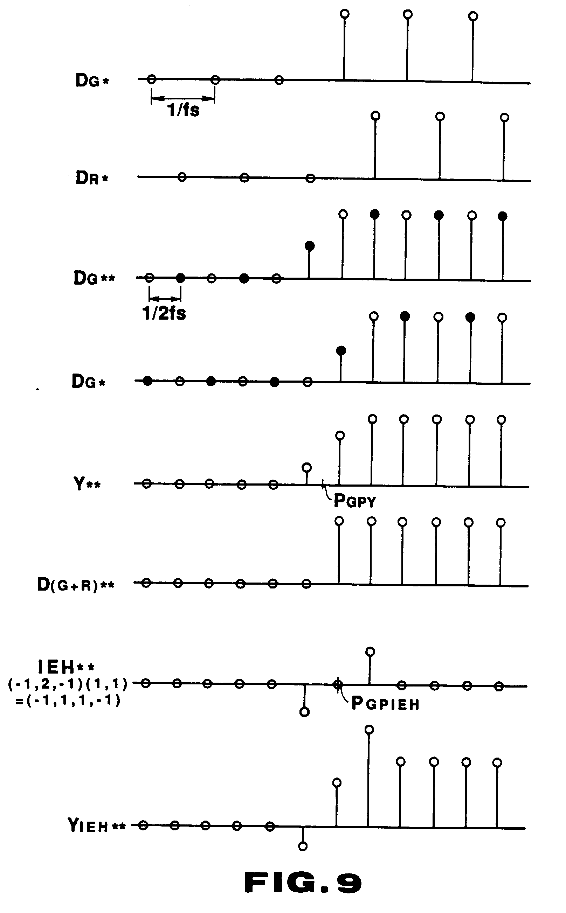

It will be noted that, if the numbers of orders m and n of the digital filters of the detail signal generator 11 and the interpolating sections 13R, 13G and 13B are not coincident as to evenness and oddness, the group delay by the digital filter for interpolation in the interpolators 13R, 13G and 13B is deviated with respect to the group delay by the differentiating digital filter for generating the detail signal in the detail signal generator 11, with the result that satisfactory image enhancement may not be achieved even upon addition of the detail signal to the interpolated signal. For example, if the even number order (second order) interpolation is performed at the signal interpolators 13R, 13G an-d 13B and an odd number order (first order) differentiation is performed at the detail signal generator 11, the center of the group delay of the luminance data Y** obtained by summing 2 fs rate green color data D_{G**} to red color data D_{R**}, obtained in turn by second order interpolation of the fs rate green color data D_{G*} and red color data D_{R*} having a phase difference of 1/(2 fs) as shown in Fig. 9, is at the position shown at P_{GPY} shown in Fig. 9, whereas the center of the group delay of the horizontal detail signal IEH** obtained by first order differentiation of the 2 fs clock rate signal D_{(G+R)**}, obtained in turn by addition of equal amounts of the fs rate green color data D_{G*} and red-color data D_{R*} after multiplexing at the 2 fs clock rate, is deviated by 1/(4 fs) with respect to the center of the group delay P_{GPY} of the luminance data Y**, as shown at P_{GPIEH}, so that the waveform of the horizontal contour compensated luminance data Y_{IEH**}, obtained upon combining the luminance data Y** with the horizontal detail signal IEH**, is not point symmetrical.

Conversely, with the present signal processing circuit, since the numbers of orders of the digital filters of the detail signal generator 11 and the interpolators 13R, 13G and 13B are coincident with each other as to evenness and oddness, the group delay by the interpolating digital filter coincides with the group delay by the differentiating digital filter adapted for generating digital signals, so that satisfactory image enhancement may be achieved even or addition of the detail signal to the previously interpolated signal.

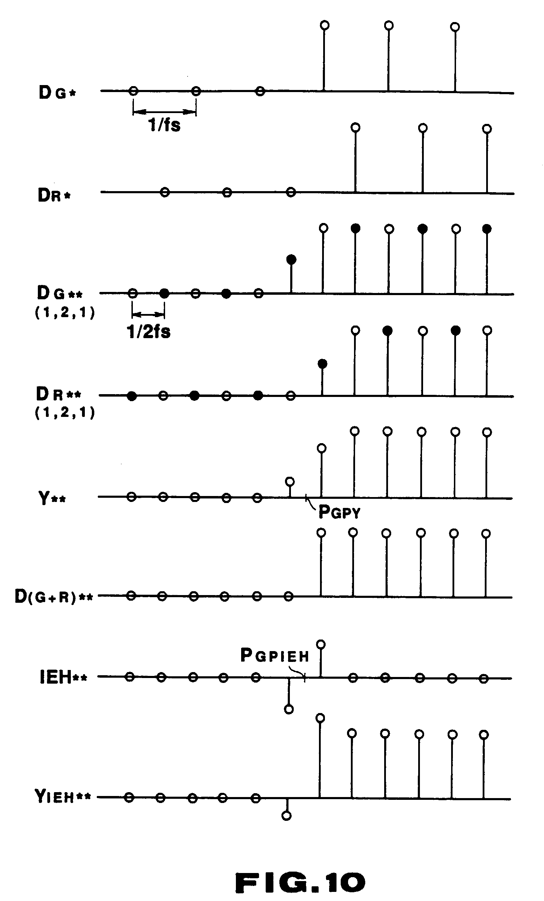

If the even number order (second order) interpolation is performed at the interpolators 13R, 13G and 13B, and the even number order (zeroth order) differentiation is performed at the detail signal generator 11, the center of the group delay of the luminance data Y**, obtained upon summation of the 2 fs rate green color data D_{G**} and red color data D_{R**}, obtained in turn by interpolating fs rate green and red color data D_{G*} and D_{R*} having a phase difference of 1/(2 fs) as shown in Fig. 10, is at at a position P_{GPY} in Fig. 10, whereas the center of the group delay of the horizontal detail signal IEH** obtained by the zeroth order differentiation of the 2 fs clock rate signal D_{(G+R)**}, obtained upon addition of equal amounts of the fs rate green and red color data D_{G*} and D_{R*} after multiplexing at the clock rate 2 fs, coincides with the center P_{GPY} of the group delay of the luminance data Y**, as shown at P_{GPIEH} in Fig. 10, such that waveform of the the horizontal contour compensated luminance data Y_{IEH**}, obtained upon combining the luminance data Y** with the horizontal detail signal IEH**, is point symmetrical with respect to the phase of the center of the group delay.

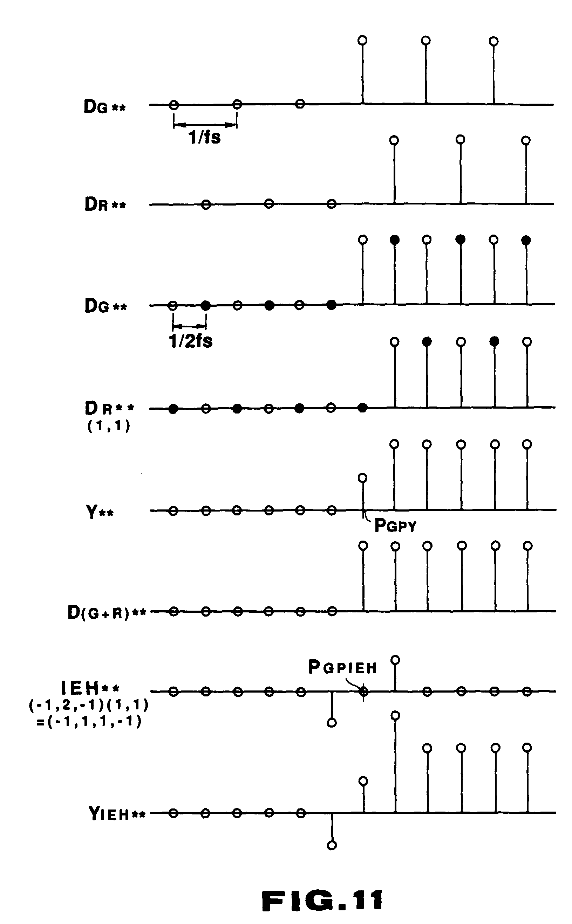

If the odd number order (first order) interpolation is performed at the interpolators 13R, 13G and 13B and the odd number order (first order) differentiation is performed at the detail signal generator 11, the center of group delay of the luminance data Y** obtained by adding the 2 fs rate green and red color data D_{G**}, D_{R**}, obtained in turn by first order interpolation of the fs rate green and red color data D_{G*} and D_{R*} having a phase difference of 1/(2 fs) to each other, as shown in Fig. 11, is at the position shown at P_{GPY} in Fig. 11, whereas the center of group delay of the horizontal detail signal IEH** obtained by first order differentiation of the 2 fs rate signal D_{(G+R)**} obtained in turn by summing equal amounts of the fs rate green and red color data D_{G*} and D_{R*} after multiplexing at the clock rate of 2 fs, coincides with the center of group delay P_{GPY} of the luminance data Y**, as shown at P_{GPIEH} in Fig. 11. Thus the horizontal contour compensated luminance data Y_{IEH**}, obtained upon summation of the luminance data Y** to the horizontal detail signal IEH**, has a waveform which is point symmetrical with respect to the phase of the center of the above mentioned group delay.

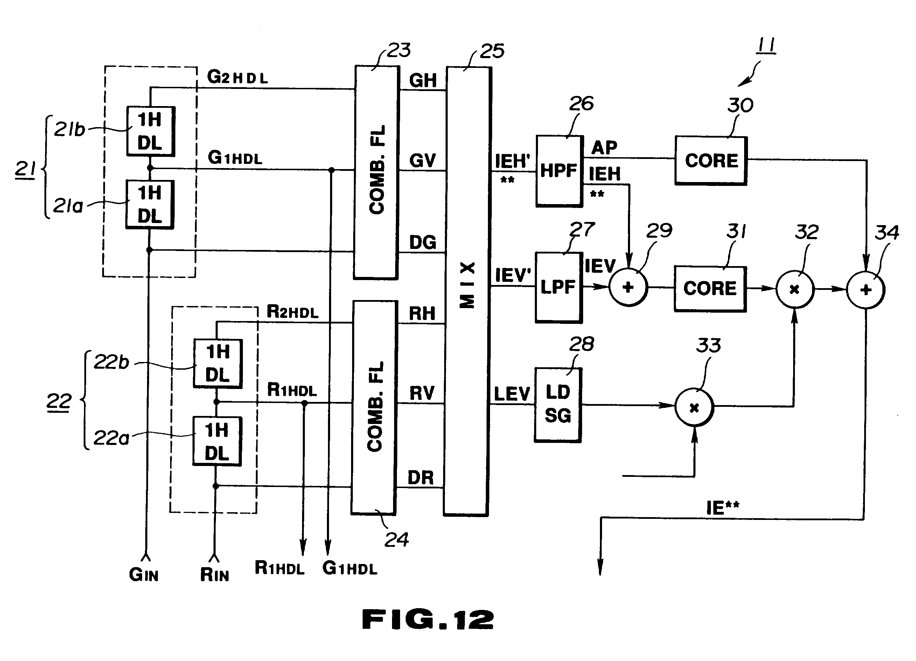

Referring to Fig. 12, showing a concrete construction of the detail signal generator 11, the generator 11 is constituted by a first delay circuit 21, to which the green color data D_{G*} is entered as input data G_{IN} from the A/D converter 6G, and a second delay circuit 22, to which the red color data D_{R*} is entered as input data R_{IN} from A/D converter 6R.

The first delay circuit 21 is made up of a series connection of two 1H delay circuits 21a, 21b for providing a delay time equal to one horizontal scanning period 1H to the input signal by means of a digital delay means= such as D-type flipflop or memory. This first delay circuit 21 transmits a OH delay output G_{IN}, 1H delay output G_{1HDL} and a 2H delay output G_{2HDL} of the green color input data GN from the A/D converter 6G to a first comb filter 23, while supplying the 1H delay output to the interpolation 13 by way of the delay circuit 12G of Fig. 5.

Similarly, the second delay circuit 22 is constituted by a series connection of two 1H delay circuits 22a, 22b providing a delay time equal to one horizontal scanning period 1H to the input signal with the aid of digital delay means such as D-type flipflop or memory. This second delay circuit 22 transmits a OH delay output R_{IN}, a 1H delay output R_{1HDL} and a 2H delay output R_{2HDL} of the red color input data R_{IN} from A/D converter 6R to a comb filter 24, while supplying the 1H delay output to the interpolator 13R by way of the delay circuit 12R.

The first comb filter 23, supplied with the green input data, G_{IN}, supplied in turn from the A/D converter 6G to the first delay circuit 21, provides filter outputs GH, GV and DG given by$\text{GH =} \frac{{\text{ω}}^{\text{-1}}}{\text{4}} {\text{{2 + (ω}}^{\text{-1}} {\text{+ ω) · G}}_{\text{IN}} \text{}}$$\text{GV =} \frac{{\text{ω}}^{\text{-1}}}{\text{4}} {\text{{2 - (ω}}^{\text{-1}} {\text{+ ω) · G}}_{\text{IN}} \text{}}$${\text{D}}_{\text{G}} {\text{= ω}}^{\text{-1}} {\text{. G}}_{\text{IN}}$ to a mixer 25 on the basis of the above mentioned three delay outputs G_{IN}, G_{1HDL} and G_{2HDL}.

On the other hand, the second comb filter 24, supplied with red color input data R_{IN}, supplied in turn from the A/D converter 6R to the second delay circuit 22, provides filter outputs RH, RV and DR given by$\text{RH =} \frac{{\text{ω}}^{\text{-1}}}{\text{4}} {\text{{2 + (ω}}^{\text{-1}} {\text{+ ω) · R}}_{\text{IN}} \text{}}$ or${\text{RH = ω}}^{\text{-1}} {\text{. R}}_{\text{IN}}$$\text{RV =} \frac{{\text{ω}}^{\text{-1}}}{\text{4}} {\text{{2 + (ω}}^{\text{-1}} {\text{+ ω) · R}}_{\text{IN}} \text{}}$ to the mixer 25 on the basis of the above mentioned three delay outputs R_{IN}, R_{1HDL} and R_{2HDL} from the second delay circuit 22.

The mixer 25, supplied with the filter outputs GH, GV and DG from the first comb filter 23 and with the filter outputs RH, RV and DR from the second comb filter 24, outputs combined outputs IEH', IEV' and LEV given by$\text{IEH' = GH + RH}$$\text{IEV' = GV + α · RV} \text{(α = 0, 1/4, 1/2, 1)}$$\text{LEV = GH + β · RH}$

The combined output IEH' from the mixer 25 is supplied to the first digital filter circuit 26 as a 2 fs rate horizontal detail signal, obtained by summing equal amounts of the filter output GH from the first comb filter 23 and the filter output RH from the second filter 24 after multiplexing at the clock rate of 2 fs.

With the above described color television camera in which the imaging section is constructed under spatial offsetting principle, the filter output GH from the first comb filter 23 and the filter output RH from the second comb filter 24 are summed together in equal amounts in the mixer 25 of the detail signal generator 11 which is supplied with the red and green color data D_{G*} and D_{R*} from the A/D converters 6R and 6G, whereby the first order carrier components are cancelled and a broad range horizontal detail signal IEH' free of aliasing distortions may be generated.

On the other hand, the above mentioned combined signal IEV′, obtained by summing the filter output GV from the first comb filter 23 and the filter output RV from the second comb filter 24 together at the mixer 25 at a ratio of 1:α, is supplied as the vertical detail signal to a second digital filter circuit 27.

The above mentioned combined output LEV, obtained by summing the filter output GH or DG from the first comb filter 23 and the filter output RH or DR from the second comb filter 24 together at the mixer 25 at a ratio of 1:β, is supplied as the level signal to a level dependent signal generator 28.

The above mentioned first digital filter circuit 26, supplied with the above mentioned combined output IEH' from the mixer circuit 25 as the 2 fs rate horizontal detail signal, has bypass filtering characteristics having at least two or more even number zero points at fs, and generates a 2 fs rate horizontal detail signal.

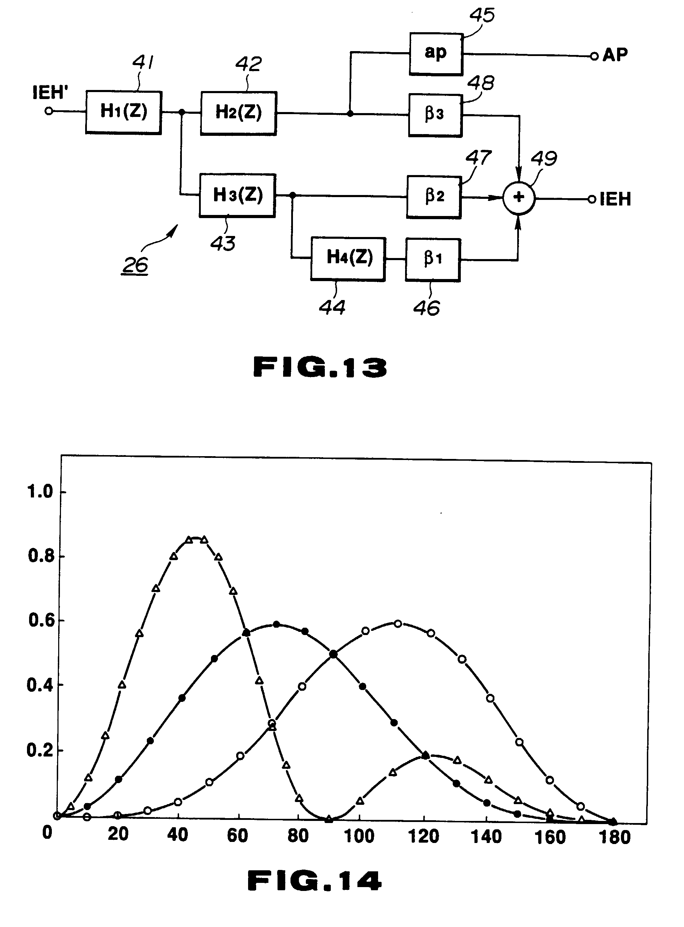

The first digital filter 26, an equivalent block construction of which is shown in Fig. 13, is constituted by a first filter block 41 represented by a transfer function H₁(z) (16)${\text{H}}_{\text{1}} \text{(z) =} \frac{\text{1}}{\text{4}} {\text{(-z}}^{\text{-4}} {\text{+ 2}}_{\text{z}} {}^{\text{-2}} \text{- 1)}$ a second filter block 42 represented by a transfer function H₂(z) (17)${\text{H}}_{\text{2}} \text{(z) =} \frac{\text{1}}{\text{4}} {\text{(-z}}^{\text{-2}} {\text{+ 2}}_{\text{z}} {}^{\text{-1}} \text{- 1)}$ a third filter block 43 represented by a transfer function H₃(z) (18)${\text{H}}_{\text{3}} \text{(z) =} \frac{\text{1}}{\text{4}} {\text{(-z}}^{\text{-2}} {\text{+ 2}}_{\text{z}} {}^{\text{-1}} \text{- 1)}$ a fourth filter block represented by a transfer function H₄(z) (19)${\text{H}}_{\text{4}} \text{(z) =} \frac{\text{1}}{\text{4}} {\text{(-z}}^{\text{-4}} {\text{+ 2}}_{\text{z}} {}^{\text{-2}} \text{- 1)}$ coefficient circuit 45 to 48 providing weighting coefficient ap, β_{1,} β_{2,} and β₃ ; and a summation circuit 49 summing the outputs of the coefficient circuits 45 to 48.

The first digital filter circuit 26 operates at a processing rate 2 fs to provide filtering characteristics shown in Fig. 14 to the combined output IEH' from the mixer 25 to form filter outputs IEH and AP as shown by$\text{IEH =} \frac{\text{1}}{\text{4}} {\text{(-z}}^{\text{-4}} {\text{+ 2z}}^{\text{-2}} \text{- 1)} \text{× {} \frac{{\text{β}}_{\text{1}}}{\text{16}} {\text{(-z}}^{\text{-4}} {\text{+2z}}^{\text{-2}} {\text{+1).(z}}^{\text{-2}} {\text{+2z}}^{\text{-1}} \text{+1)} \text{+} \frac{{\text{β}}_{\text{2}}}{\text{4}} {\text{(z}}^{\text{-2}} {\text{+2z}}^{\text{-1}} \text{+1)} \text{+} \frac{{\text{β}}_{\text{3}}}{\text{4}} {\text{(-z}}^{\text{-2}} {\text{+2z}}^{\text{-1}} \text{-1)}.IEH'}$$\text{AP =} \frac{\text{ap}}{\text{16}} {\text{(-z}}^{\text{-4}} {\text{+2z}}^{\text{-2}} \text{+1)} {\text{× (-z}}^{\text{-2}} {\text{+2z}}^{\text{-1}} \text{-1)}$

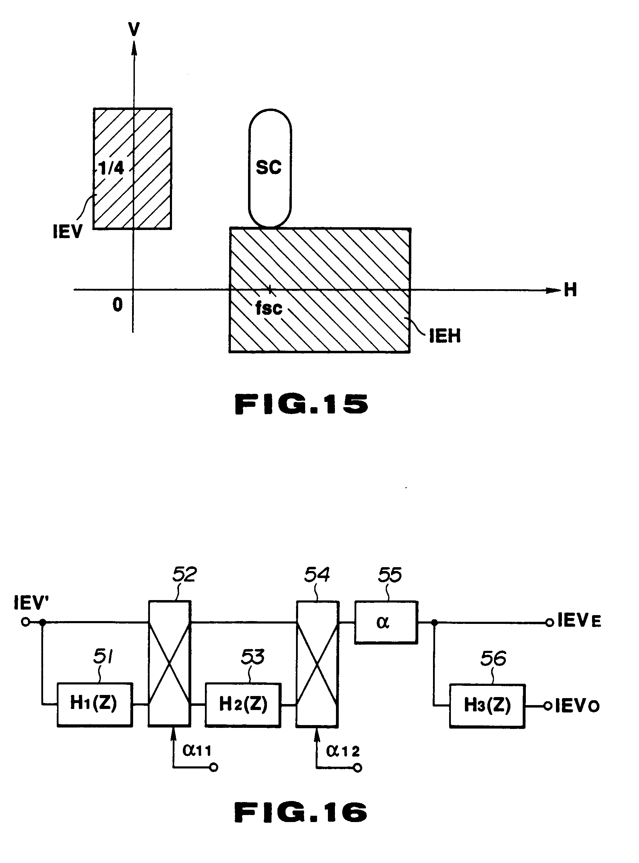

It is noted that the combined output from the mixer 25 is a combination of the filter output GH from the first comb filter 23 and the filter output RH from the second comb filter 24, and is band-limited by the comb filters 23 and 24 in the vertical direction on a two-dimensional frequency space shown in Fig. 15. The horizontal detail signal IEH, obtained by band-limiting the combined output IEH' in the horizontal direction by the first digital filter circuit 26 having by-pass filtering characteristics having at least two zero points at fs in the vicinity of the color subcarrier frequency fsc of the composite color image signal, contains only a minor amount of unnecessary leakage components into the region of color subcarrier frequency SC (fsc, 1/4) on the two-dimensional frequency space shown in Fig. 15, and may be subjected to a high quality horizontal contour enhancement operation without cross-color interferences.

The filter output IEH by the first digital filter 26 is supplied as the horizontal detail signal to the summation circuit 29, while, the filter output AP is supplied to summation circuit 34 by way of a first core circuit 30 performing a non-linear operation.

The second digital filter 27, an equivalent block diagram of which is given in Fig. 16, is constituted by a first filter block 51 providing a transfer function H₁(z) (22)${\text{H}}_{\text{1}} \text{(z) =} \frac{\text{1}}{\text{4}} {\text{(z}}^{\text{-8}} {\text{+ 2z}}^{\text{-4}} \text{- 1)}$ to the vertical detail signal IEV' from the mixer 25, a first switching circuit block 52 for selecting the filter output signal from the first filter block 51 or the vertical detail signal IEV' for switching filter characteristics, a second filter block 53 providing a transfer function H₂(z) (23)${\text{H}}_{\text{2}} \text{(z) =} \frac{\text{1}}{\text{4}} {\text{(z}}^{\text{-4}} {\text{+ 2z}}^{\text{-2}} \text{- 1)}$ to the first selection output signal from the first switching circuit block 52, a second switching circuit block 54 for selecting the filter output signal from the second filter block 53 or the first selection output signal for switching filtering characteristics, a coefficient circuit 55 for multiplying the second selection output signal from the second switching circuit block 54 by a weighting coefficient α, and a third filter block 56 providing a transfer function H₃(z) (24)${\text{H}}_{\text{3}} \text{(z) =} \frac{\text{1}}{\text{2}} {\text{(1 + z}}^{\text{-2}} \text{)}$ to the output signal from the coefficient circuit 55.

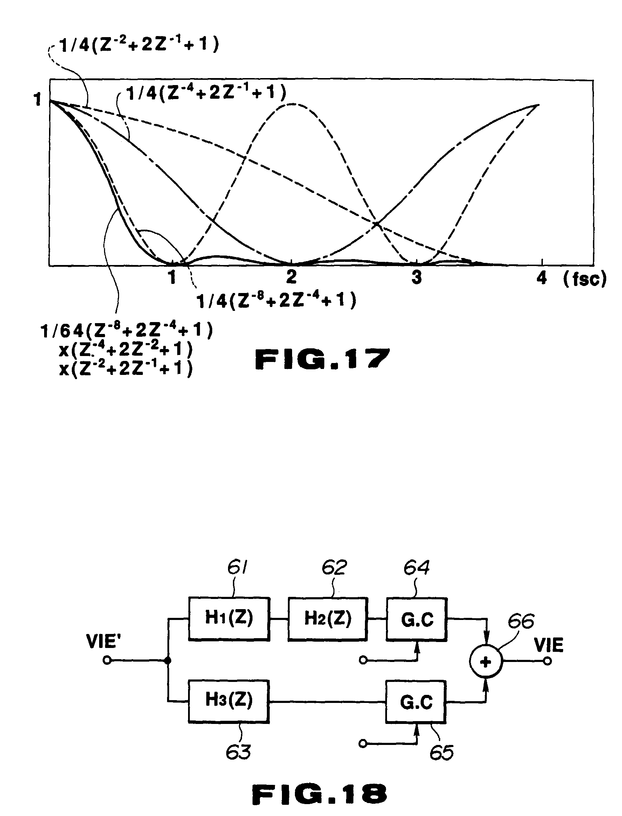

The second digital filter circuit 27 operates at a processing rate fs on the fs rate vertical detail signal IEV', provided with filtering characteristics H(z) (25)$\text{H(z) =} \frac{\text{1}}{\text{4}} {\text{(z}}^{\text{-2}} {\text{+ 2z}}^{\text{-1}} \text{+ 1)}$ by the comb filters 23, 24 to provide filtering characteristics H₁(z) having a zero point at fsc as shown by a broken line and filtering characteristics H₂(z) having a zero point at 2 fsc, as shown by a chain-dotted line in Fig. 17, to form a vertical detail signal IEV having a transfer function H₀(z) (26)${\text{H}}_{\text{0}} \text{(z) =} \frac{\text{1}}{\text{64}} {\text{(z}}^{\text{-8}} {\text{+ 2z}}^{\text{-4}} \text{+ 1)} {\text{× (z}}^{\text{-4}} {\text{+ 2z}}^{\text{-2}} \text{+ 1)} {\text{× (z}}^{\text{-2}} {\text{+ 2z}}^{\text{-1}} \text{+ 1)}$ as shown by a solid line in Fig. 17, which vertical detail signal is supplied to the summation circuit 29.

It is noted that the vertical signal IEV' is combined from the filter output GV from the first comb filter 23 and the filter output RV from the second comb filter 24, and is band-limited by these comb filters 23, 24 in the vertical direction on the two-dimensional frequency space of Fig. 15. The vertical detail signal IEV, produced by band limitation in the horizontal direction by the second digital filter circuit 27 having two or more zero point in the vicinity of the color subcarrier frequency fsc of the composite color image signal, contains only a minor amount of unnecessary leakage components into the region of the color subcarrier frequency SC (fsc, 1/4) on the two-dimensional frequency space of Fig. 15 and may be subjected to high quality vertical contour enhancement operation without cross-color interference.

Fig. 18 shows, in an equivalent block diagram, a modified embodiment of the second digital filter circuit 27. The present digital filter circuit is constituted by a first filter block 61, providing a transfer function H₁(z) (27)${\text{H}}_{\text{1}} \text{(z) =} \frac{\text{1}}{\text{4}} {\text{(z}}^{\text{-8}} {\text{+ 2z}}^{\text{-4}} \text{+ 1)}$ to the vertical detail signal IEV' from the mixer 25, a second filter block 62 providing a transfer function H₂(z) (28)${\text{H}}_{\text{2}} \text{(z) =} \frac{\text{1}}{\text{4}} {\text{(z}}^{\text{-4}} {\text{+ 2z}}^{\text{-2}} \text{+ 1)}$ to the filter output from the first filter block 61, a third filter block 63 providing a transfer function H₃(z) (29)${\text{H}}_{\text{3}} \text{(z) =} \frac{\text{1}}{\text{4}} {\text{(z}}^{\text{-8}} {\text{+ 2z}}^{\text{-4}} \text{+ 1)}$ to the vertical detail signal IEV' from mixer 25, a first gain adjustment circuit 63 for adjusting the signal level of the filter output signal, to which the transfer function H₁(z)·H₂(z) are provided by the first and second filter blocks 61, 62, a second gain adjustment circuit 65 for adjusting the signal level of the filter output signal, to which the transfer function H₃(z) is provided by the third filter block 63, and a summation circuit 66 for summing the level-adjusted filter output signals from the gain adjustment circuits 64, 65.

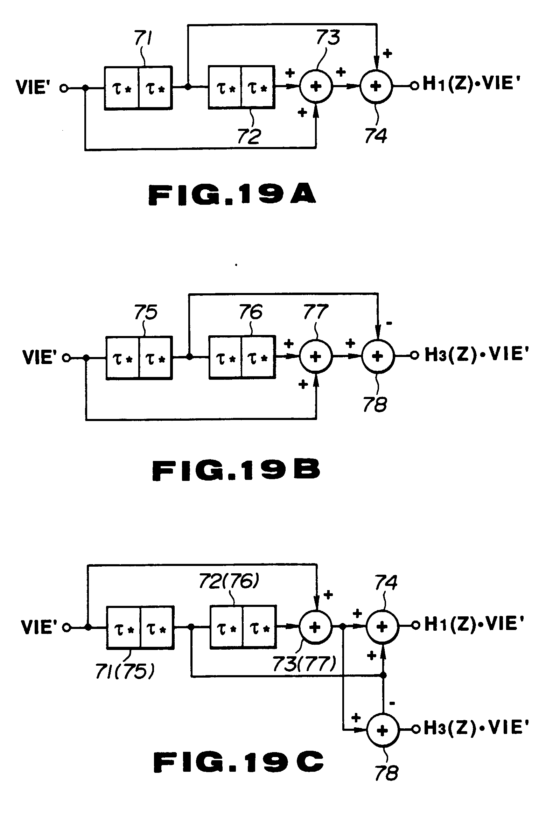

The first filter block 61 for providing the transfer function H₁(z) is constituted by two delay means 71 having a delay 2 τ*, τ* being a unit delay for the processing rate of fs, and two summation circuits 73, 74, as shown in Fig. 19A. The third filter block 63, providing the above mentioned transfer function H₃(z), is constituted by two delay means 165 having a delay 2τ*, τ* being a unit delay for the processing rate of fs, and two summation circuits 77, 78, as shown in Fig. 19B. Thus the first filter block 61 and the third filter block 63 may have the delay means 71, 72, 75, 76 and one 73, 77 of the summation circuits in common, as shown is Fig. 19C.

The second digital filter circuit 27 of the present modification operates on the vertical detail signal IEV' from the mixer 25 at the processing rate fs to form the vertical detail signal IEV containing superimposed cross-color suppression signals suppressing cross-color interference components into the region of the color subcarrier frequency SC (fsc, 1/4) on the two-dimensional space shown in Fig. 15.

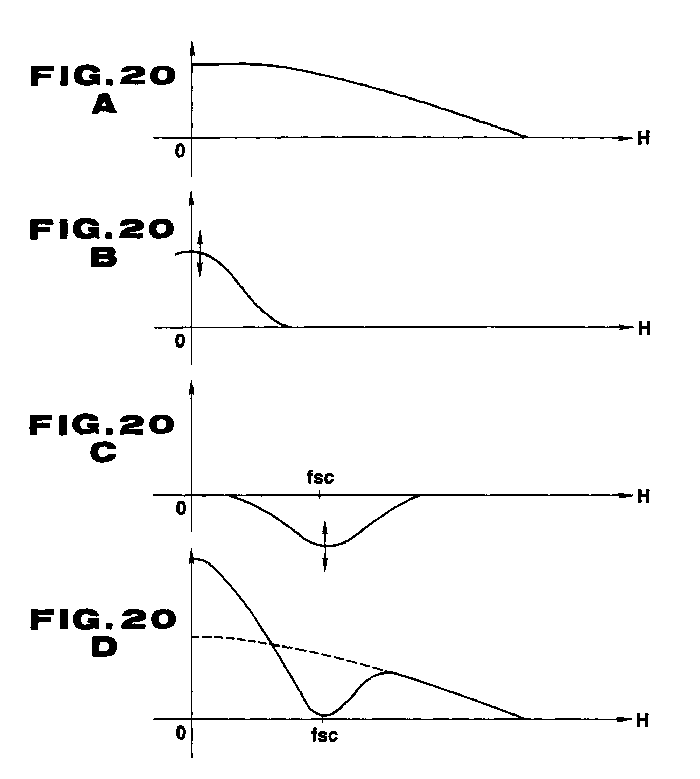

That is, the first and second filter blocks 61, 62 in the second digital filter circuit 27 provide filtering characteristics H₁(z) having a zero point at fsc as shown by a broken line in Fig. 17 and a zero point at 2 fsc as shown by a chain-dotted line in Fig. 17, to the fs rate vertical detail signal IEV', to which filtering characteristics H(z) given by$\text{H(z) =} \frac{\text{1}}{\text{4}} {\text{(z}}^{\text{-2}} {\text{+ 2z}}^{\text{-1}} \text{+ 1)}$ are provided by the above mentioned comb filters 23 and 24, for producing vertical detail signal IEV having the transfer function H₀(z)${\text{H}}_{\text{0}} \text{(z) =} \frac{\text{1}}{\text{64}} {\text{(z}}^{\text{-8}} {\text{- 2z}}^{\text{-4}} \text{- 1)} {\text{× (z}}^{\text{-4}} {\text{+ 2z}}^{\text{-2}} \text{+ 1)} {\text{× (z}}^{\text{-2}} {\text{+ 2z}}^{\text{-1}} \text{+ 1)}$ as shown by the solid line in Fig. 17. That is, by virtue of the two-pass filtering characteristics having two or more zero points in the vicinity of the color subcarrier frequency fsc of the composite color video signal, the first and the second filter blocks 61, 62 generate the vertical detail signal IEV which is band-limited in the horizontal direction. This vertical detail signal IEV contains only an extremely small amount of wasteful leakage components into the region of the color subcarrier frequency SC (fsc, 1/4), as shown in Fig. 20D showing the response at the cross-section of the horizontal line contained in the region of the color subcarrier frequency SC (fsc, 1/4) in the two-dimensional frequency space of Fig. 15. Meanwhile, the vertical detail signal IEV' is the sum of the filter output GV from the first comb filter 23 and the filter output RV from the second comb filter 24, and is band-limited in the vertical direction on the two-dimensional frequency space of Fig. 15 by the above mentioned comb filters 23 and 24. Also the third filter block 63 provides the above mentioned transfer function H₃(z) to the vertical detail signal IEV' from mixer 25 to generate cross-color suppression signals having a negative response in the vicinity of the color subcarrier frequency fsc of the composite color video signal, as shown in Fig. 20C. The summation circuit 66 transmits the vertical detail signal IEV with the cross-color suppression signal superimposed thereon to the summation circuit 29.

The vertical detail signal IEV, on which the cross-color suppression signal is superimposed, is summed to the signal on the main line to enhance the baseband component and to suppress the signal level in the region of the color subcarrier frequency SC (fsc 1/4) in the two-dimensional space of Fig. 15, as shown in Fig. 20D, to perform high-quality vertical contour enhancement without accompanying cross-color interferences.

Meanwhile, it is not always necessary to get the cross-color suppression signal superimposed on the vertical detail signal IEV in the inside of the digital filter circuit 27, but the cross-color suppression signal may be generated at an output stage of the detail signal generator 11.

The summation circuit 29 operates at a sampling rate of 2 fs to sum the 2 fs clock rate horizontal detail signal IEH from the first digital filter circuit 26 and the fs clock rate vertical detail signal IEV from the second digital filter circuit 27. The 2 fs clock rate summation output signal from the summation circuit 29 is supplied to a multiplication circuit 32 by way of a second core circuit 31 adapted for performing a non-linear processing operation.

The level-dependent signal generator 28, to which the combined output LEV from the mixer 25 is supplied as the level signal, generates a level-dependent signal LD as a function of the level signal LEV, and transmits the level-dependent signal to the multiplication circuit 32 by way of a multiplication circuit 33 adaptec for multiplying the level-dependent signal LD by an weighting coefficient.

The multiplication circuit 32 multiplies the summation output signal from the circuit 29, which has been subjected at the second core circuit 31 to the non-linear processing operation, by the level-dependent signal LD multiplied by the weighting coefficient at the multiplication circuit 33, and transmits the multiplication output signal to the summation circuit 34.

The summation circuit 34 sums the filter output AP from the first digital filter circuit 25, previously subjected to the non-linear processing at the first core circuit 30, to the multiplication output signal from the multiplication circuit 32, and outputs the sum output as the 2 fs clock rate detail signal D_{IE**}.

The summation circuit 14R, 14G and 14B, to which the 2 fs clock detail signal D_{IE**} is supplied from the above described detail signal generator 11, sums the 2 fs clock rate detail signal D_{IE**} to the 2 fs rate three-color data D_{R**}, D_{G**} and D_{B**} from the interpolators 13R, 13G and 13B to perform an enhancement operation. The summation circuits 14R, 14G and 14B transmit the image enhanced three-color data D_{R**}, D_{G**} and D_{B**} to the gamma compensation circuits 15R, 15G and 15B.

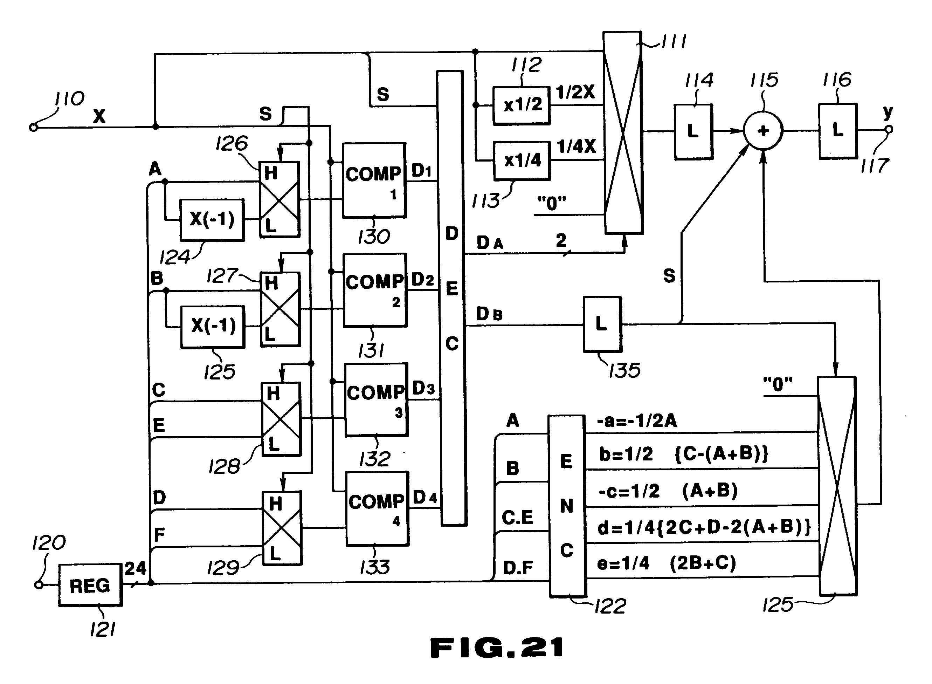

The second core circuit 31 performs, on the sum output signal of the horizontal detail signal IEH from the summation circuit 29 and the vertical detail signal IEV, a non-linear arithmetic operation in which compression characteristics may be set independently on the positive and negative sides with respect to a predetermined level, and is constructed as shown for example in Fig. 21.

In this figure, a signal level data x of the summation output signal of the horizontal data signal IEH and the vertical detail signal IEV from the summation circuit 29 is supplied to a data input terminal 110. Control data setting the operating characteristics of the second core circuit 31 are supplied to the second data input terminal 120.

The signal level data x is directly applied from first data input terminal 110 to data selector 111, while being applied to the data selector 1 by way of a 1/2 multiplication circuit 112 and a 1/4 multiplication circuit 113.

The zero (0) value data is applied to the data selector 111 as the fourth input data. The data selector 111 is responsive to 2-bit control data from a decoder 134 as later described to select one of input data, that is, the signal level data x, the output data x/2 from the 1/2 multiplication circuit 112, the output data x/4 from the 1/4 multiplication circuit 113 or the zero (0) data, and transmits the selected output data to a summation circuit 115 by way of a latch circuit 114.

The summation circuit 115 sums coefficient data from a data selector 123 as later described to selected output data from data selector 111 applied from the latch circuit 114 to transmit the sum output data to a data output terminal 117 by way of a latch circuit 116 as compressed output data (y).

Polarity data (s) of the signal level data (x) supplied to the first data input terminal 110 is applied to the first to fourth data selectors 126, 127, 128 and 129 and to the decoder 134. The signal level data (x) is also supplied to first to fourth data comparators 130, 131, 132 and 133.

Control data supplied to the second data input terminal 120 are stored in a register 121 and applied thence to an encoder 122, while also being applied by way of the first to fourth data selectors 126 to 129 to the first to fourth data comparators 130 to 133.

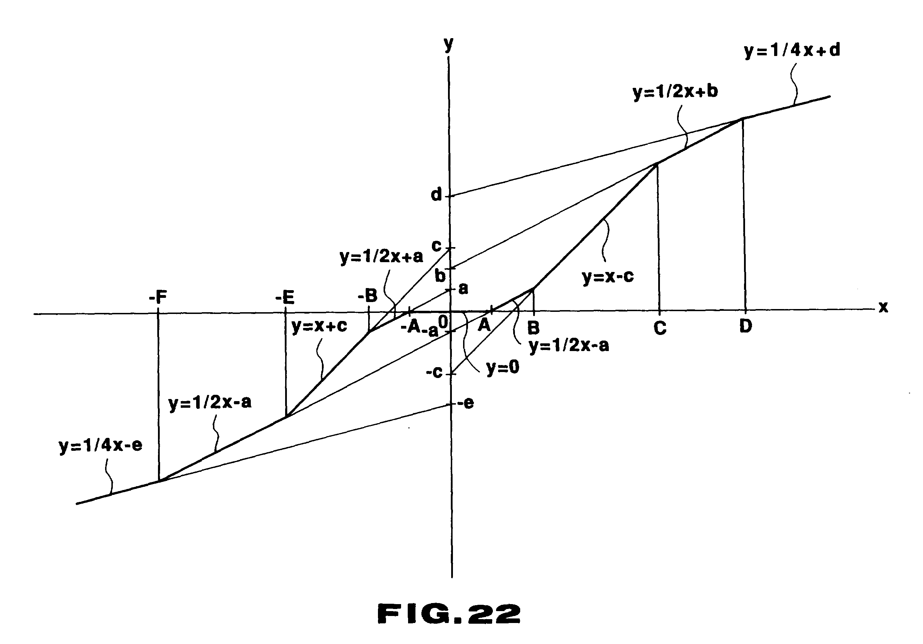

The control data stored in the register 121 are the control values +A, +B, +C, +D, -E and -F which are related to one another by an equation

-F < -E < O < +A < +B < +C < +D

in correspondence with the signal levels at the knee points on operational characteristics in the form of folded lines shown in Fig. 22.

The encoder 122 forms, on the basis of the control values +A, +B, +C, +D, -E and -F represented by the control data, coefficient data (-a), (b), (-c), (d) and (e) shown by the formulas (32) to (35):$\text{-a = -} \frac{\text{1}}{\text{2}} \text{A}$$\text{b =} \frac{\text{1}}{\text{2}} \text{{C - (A + B)}}$$\text{-c = -} \frac{\text{1}}{\text{2}} \text{(A + B)}$$\text{d =} \frac{\text{1}}{\text{4}} \text{{2C + D - 2 (A + B)}}$ to transmit these coefficient data to data selector 123.

The data selector 123 is also supplied with the zero (0) value data. The data selector is responsive to control data supplied from decoder 134 by way latch circuit 135 to select one of input data, that is the coefficient data (-a), (b) or (-c) or zero value data (0), to transmit the selected data to the summation circuit 115.

The first to fourth data selectors 126, 127, 128 and 129 operate to select one of the control values (+A), (+B), (+C), (+D), (-E) or (-F), represented by control data stored in register 121, as a function of polarity data s of the signal level data (x), supplied to the first data input terminal 110, in the following manner:

That is, the first data selector 126 selectively transmits the control value (+A), represented by the control data, or the control value (-A), obtained by multiplying the control value (+A) by a coefficient (-1) at a -1 multiplication circuit 124 and inverting the signal polarity, to the first data comparator 130. Thus the data selector 126 selects the control value (+A) or (-A) when the signal level data (x) is positive or negative, respectively. The second data selector 127 selectively transmits the control value (+B) shown by the above control data or the control value (-B) obtained by multiplying the control value (+B) by a coefficient (-1) at a - 1 multiplication circuit 125 and inverting the signal polarity, to the second data comparator 131. Thus the data selector 127 selects the control value (+B) or (-B) when the signal level data (x) is positive or negative, respectively. The third data selector 128 selectively transmits the control value (-C) or (-F) shown by the above control data to the third data comparator 132 and selects the control value (+C) or (-E) when the signal level data (x) is positive a negative, respectively. Finally the fourth data selector 129 selectively transmits the control value (+D) or (-F), shown by the above control data, to the fourth data comparator 133. Thus the data selector 129 selects the control value (+D) or (-F) when the signal level data (x) is positive or negative, respectively.

The first to fourth data comparators 130 to 133 compare the signal level data (x) from the first data input terminal 110 to the control values (+A), (-A), (+B), (-B), (+C), (-E), (+D) and (-F), selected by the first to fourth data selectors 126 to 129, to transmit the following comparison outputs to decoder 134.

That is, the first data comparator 130 compares the signal level data (x) to the control values (+A) and (-A) selected by first data selector 126 to transmit to decoder 134 a comparison output D₁ which goes low and high when the signal level data (x) is within and outside the range of (+A) to (-A), respectively. The second data comparator 131 compares the signal level data (x) to the control values (+B) and (-B) selected by second data selector 127 and transmits to decoder 134 a comparison output (D₂) which goes low and high when the signal level data (x) is within and outside the range (+B) to (-B), respectively. The third data comparator 132 compares the signal level data (x) to the control values (+C) and (-E) selected by the third data selector 127 to transmit to decoder 134 a comparison output (D₃) which goes low and high when the signal level data (x) is within and outside the range of the control values (+C) to (-E), respectively. The fourth data comparator 133 compares the signal level data (x) to the control values (+D) and (-F) selected by the fourth data selector 128 to transmit to decoder 134 a comparison output (D₄) which goes low and high when the signal level data (x) is within and outside the range of the control values (+D) to (-F), respectively.

The decoder 134 decodes the polarity data (s) of the signal level data (x) and the comparison output data (D₁), (D₂), (D₃) and (D₄) from the first to fourth data comparators 130 to 133 to form control data (D_{A}) for data selector 111 and control data (D_{B}) for data selector 123 for designating data selected by data selectors 111, 123, as shown in Table 2.

**Table 1**

| Table Showing Decoder Operation | | | | | | | | |
|---|---|---|---|---|---|---|---|---|
| input data | decoder inputs | | | | | | control data | |
| x | s | D₁ | D₂ | D₃ | D₄ | D_{A} | D_{B} | s |
| x>+D | H | H | H | H | H | x/4 | d | H |
| +D≥x>+C | H | H | H | H | L | x/2 | b | H |
| +C≥x>+B | H | H | H | L | L | x | -c | H |
| +B≥x>+A | H | H | L | L | L | x/2 | -a | H |
| +A≥x> O | H | L | L | L | L | 0 | 0 | H |
| O≥x>-A | L | L | L | L | L | 0 | 0 | H |
| -A≥x>-B | L | H | L | L | L | x/2 | a | L |
| -B≥x>-E | L | H | H | L | L | x | c | L |
| -E≥x>-F | L | H | H | H | L | x/2 | a | H |
| -F≥x | L | H | H | H | H | x/4 | e | L |

The summation circuit 115, supplied with data selected at data selects 111, 123 as a function of the control data D_{A} and D_{B} from decoder 134, sums the selected output data supplied from data selector 111 via latch circuit 114 to the coefficient data from the data selector 123 to output, as shown in Fig. 12, an output data (y) (37)$\text{y =} \frac{\text{1}}{\text{4}} \text{x - d}$ for the range of x>+D, an output data (y) (38)$\text{y =} \frac{\text{1}}{\text{2}} \text{x - b}$ for the range of +D≥x>+C, an output data (y) (39)$\text{y = x - c}$ for the range of +C≥x>+B, an output data (y) (40)$\text{y =} \frac{\text{1}}{\text{2}} \text{x - a}$ for the range of +B≥x>+A, an output data (y) (41)$\text{y = 0}$ for the range of +A≥x>-A, an output data (y) (42)$\text{y =} \frac{\text{1}}{\text{2}} \text{x - a}$ for the range of -A≥x>-B, an output data (y) (43)$\text{y = x + c}$ for the range of -B≥x>-E, an output data (y) (44)$\text{y =} \frac{\text{1}}{\text{2}} \text{x - a}$ for the range of -E≥x>-F, and an output data (y) (45)$\text{y =} \frac{\text{1}}{\text{4}} \text{x - e}$ for the range of -F≥x.

That is, the second core circuit 31 performs a non-linear compressing operation which differs on the positive and negative side with respect only to the polarity for the range +B≥x>-B, while performing a non-linear compressing operation which differs on the positive and negative sides with respect to the compression characteristics outside the range of +B≥x>-B, and a clipping operation of setting y to zero (y=0) outside the range of +A≥x>-A.

The characteristics of the non-linear compression operation of the second core circuit 31 shown in Fig. 22 is to modify the control values (+A), (+B), (+C), (+D), (-E) and (-F) shown by control data supplied to register 121 to modify the position of knee points to set the ranges of various inclinations optionally and independently.

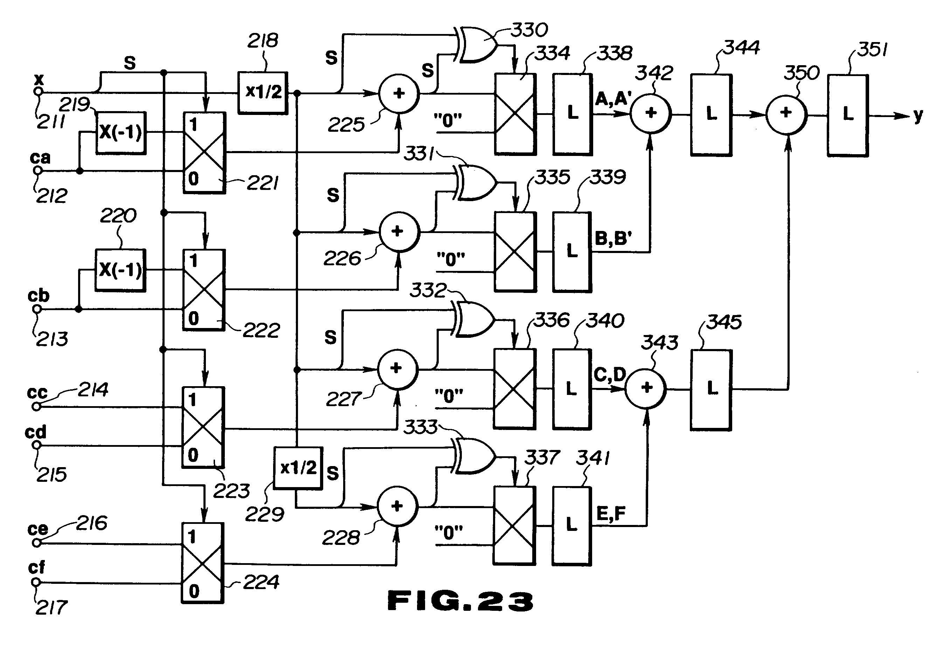

The second core circuit 31 for setting the ranges of various inclinations optionally and independently may be implemented as shown in Fig. 23.

Referring to Fig. 23 showing an alternative arrangement of the second core circuit 31, a signal level data (x) of a summation output signal of the vertical detail signal IEV and the horizontal detail signal IEH from the summation circuit 29 is supplied to first data input terminal 211. Control data (ca), (cb), (cc), (cd), (ce) and (cf), providing the points of intersection with the Y axis of the characteristic lines (A), (A'), (B), (B'), (c), (D), (E) and (F), governing the operational characteristics of the second core circuit 31, are transmitted to second to seventh data input terminals 212, 213, 214, 215, 216 and 217, respectively.

The signal level data x is supplied from first data input terminal 211 to first 1/2 multiplication circuit 218, while polarity data s thereof is supplied as selection control data to first to fourth data selectors 221, 222, 223 and 224.

The control data (ca) is supplied from second data input terminal 212 to first data selector 221 directly and by way of-1 multiplication circuit 219. The first data selector 221 performs a selective operation as a function of the polarity data, s in such a manner that, when the magnitude of the signal level data x is positive, the inverted polarity value (-ca) from -1 multiplication circuit 219 is selected and, when the magnitude of the signal level data (x) is negative, the control data ca is selected. The selected output data from first data selector 221 is supplied to first summation circuit 225.

The control data (cb) is supplied from the third data to the second data selector 222 both directly and by way of -1 multiplication circuit 220. The second data selector 222 performs a selective operation as a function of the polarity data s, in such a manner that, when the magnitude of the signal level data x is positive, the inverted polarity data -cb from -1 multiplication circuit 220 is selected and, when the magnitude of the signal level data x is negative, the control data cb is selected. The selected output data from the second data selector 222 is applied to second summation circuit 226.

The control data (cc) is applied from fourth data input terminal 214 to third data selector 223. The control data (cd) is applied from fifth data input terminal 215 to third data selector 223. This third data selector 223 performs a selective operation as a function of the polarity data s, in such a manner that, when the magnitude of the signal level data x is positive or negative, the control data (cc) or (cd) is selected, respectively. The selection data from third data selector 223 is applied to third summation circuit 227.

The control data (ce) is applied from sixth data input terminal 226 to fourth data selector 224. The control data (cf) is applied from seventh data input terminal 217 to fourth data selector 224. The fourth data selector 224 performs a selective operation as a function of the polarity data s, in such a manner that, when the magnitude of the signal level data x is positive or negative, the control data (cc) or (cd) is selected, respectively. The selective output data from fourth data selector 224 is applied to fourth sum circuit 228.

The first 1/2 multiplication circuit 21B performs an operation of multiplying the signal level data x from first data input terminal 211 by a coefficient 1/2. The first 1/2 multiplication circuit 218 applies its multiplication output x/2 to first to third multiplication circuits 225 to 227 and to second 1/2 multiplication circuit 229, while applying its polarity data s to first to third exclusive OR circuit 330 to 332. The second 1/2 multiplication circuit 229 performs an operation of multiplying the multiplication output x/2 from first 1/2 multiplication circuit 218 by a coefficient 1/2. This second 1/2 multiplication circuit 229 applies its multiplication output x/4 to fourth summation circuit 228, while applying its polarity data s to fourth exclusive OR circuit 333.

The first summation circuit 225 multiplies the control data (-ca) or (ca) selected at the first data selector 221 as a function of the polarity of the signal level data x by multiplication output x/2 from first 1/2 multiplication circuit 218 to output a summation output (x/2-ca) or (x/2+ca) when the signal level data is positive or negative respectively. This first summation circuit 225 applies its sum output to fifth data selector 334, while applying its polarity data s to first exclusive OR circuit 330.

This first exclusive OR circuit 330 takes an exclusive OR of the polarity data s of the multiplication output x/2 from first 1/2 multiplication circuit 218 and the polarity data s of the sum output of first sum circuit 225 to transmit an exclusive OR output which goes low when the magnitude of the sum output (x/2-ca) is negative or the magnitude of the sum output (x/2+ca) is positive and which goes high otherwise to fifth data selector 334 as control data.

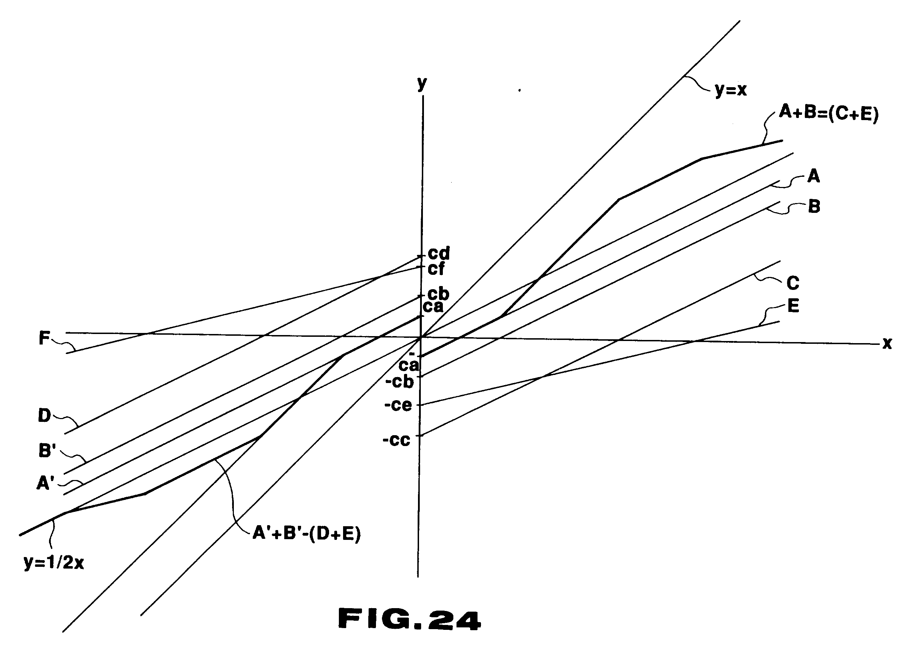

A zero (0) data is supplied as second selection data to fifth data selector 334. This fifth data selector 334 performs a selective operation as a function of the exclusive OR output from first exclusive OR circuit 330, in such a manner that, when the exclusive OR output is low or high, the zero (0) value data or the sum output from first summation circuit 225 is selected, respectively. The selection output from fifth data selector 334 corresponds to characteristic lines (A)/(A′) shown in Fig. 24. The selection output from fifth data selector 334 is applied via first latch circuit 338 to fifth summation circuit 342.

The second summation circuit 226 sums control data (-cb) or (cb), selected by second data selector 222 as a function of the polarity of signal level data x to the multiplication output x/2 from 1/2 multiplication circuit 218 to output the addition output (x/2-cb) or (x/2+cb) for the positive or negative signal level data x, respectively. This second summation circuit 226 applies its sum output to sixth data selector 335, while applying it polarity data s to second exclusive OR circuit 331.

This second exclusive OR circuit 331 takes and exclusive OR of the polarity data s of multiplication output x/2 from first 1/2 multiplication circuit 218 and the polarity data s of the sum output from second sum circuit 226 to transmit an exclusive OR output which goes low when the sum output (x/2-cb) is negative or when the sum output (x/2+cb) is positive to sixth data selector 335 as control data.

The zero (0) value data is applied as selection data to this sixth data selector 335. This sixth data selector 335 performs a selective operation as a function of the exclusive OR output from second exclusive OR circuit 331, in such a manner that, when the exclusive OR output is low or high, the zero value data or the sum output from second summation circuit 226 is selected, respectively. The selection output from sixth data selector 335 corresponds to characteristic lines (B)·(B') shown in Fig. 24. The selection output from sixth data selector 335 as applied via second latch circuit 339 to fifth summation circuit 342.

The third summation circuit 227 sums the control data (-cc) or (cd) selected by third data selector 223 as a function of the polarity of signal level data x to the multiplication output x/2 from first 1/2 multiplication circuit 218 to output the summation output (x/2-cc) or (x/2+cc) for the positive or negative value of signal level data x, respectively. This third summation circuit 223 applies its summation circuit to a seventh data selector 336 while applying its polarity data 5 to third exclusive OR circuit 332.

This third exclusive OR circuit 332 takes an exclusive OR of the polarity data s of the multiplication output x/2 from 1/2 multiplication circuit 218 and the polarity data s of the summation output from third summation circuit 227 to transmit an exclusive OR output, which goes low when the value of the sum output (x/2-cc) is negative or when the value of the sum output (x/2+cd) is positive and which goes high otherwise, to seventh data selector 336 as control data.

A zero (0) value data is applied as second selection data to seventh data selector 336. This seventh data selector 336 performs a selective operation as a function of the exclusive OR output from third excllusive OR circuit 332, in such a manner that the zero value data or the sum output from third sum circuit 227 is selected when the exclusive OR circuit is high or low, respectively. The selection output by the seventh data selector 336 corresponds to characteristic lines (C)·(D) shown in Fig. 24. The selection output from the seventh data selector 336 is applied via third latch circuit 340 to sixth summation circuit 343.

The fourth summation circuit 228 sums the control data (-ce) or (cf), selected by fourth data selector 224 as a function of the polarity of the signal level data x, to the multiplication output x/4 from second 1/2 multiplication circuit 229, in such a manner that the sum output (x/4-ce) or (x/4+cf) is outputted when the signal level data x is positive or negative, respectively. This fourth summation circuit 224 applies its sum output to eighth data selector 337, while supplying its polarity data s to fourth exclusive OR circuit 333.

This fourth exclusive OR circuit 333 takes an exclusive OR of the polarity data s of the multiplication output x/4 from second 1/2 multiplication circuit 229 and the sum output from fourth sum circuit 228 to supply an exclusive OR output, which goes low when the sum output (x/4-ce) is negative or when the sum output (x/4+cf) is positive and which goes high otherwise, to eighth data selector 337 as control data.

A zero (0) value data is applied as second selection data to eighth data selector 337. This eighth data selector 337 performs a selective operation as a function of the exclusive OR output from fourth exclusive OR circuit 333, in such a manner that the zero value data or the sum output from fourth summation circuit 228 is selected when the exclusive OR output is low or high, respectively. The selection output from this eighth data selector 337 corresponds to the characteristic lines (E)·(F) shown in Fig. 24. The selection output from this eighth data selector 337 is applied via fourth latch circuit 341 to sixth summation circuit 343.

The summation circuit 342 sums the selection output from fifth data selector 334 via first latch circuit 338 to the selection output from sixth data selector 335 via second latch circuit 339. The sum output from fifth summation circuit 343 is applied via fifth latch circuit 334 to seventh sum circuit 350. The sixth summation circuit 343 sums the selection output from seventh data selector 336 via third latch circuit 340 to the selection output from eighth data selector 337 via fourth latch circuit 341. The sum output from sixth summation circuit 343 is applied via sixth latch circuit 335 to seventh summation circuit 350. This seventh summation circuit 350 sums the sum output from fifth summation circuit 343 via fifth latch circuit 334 to the sum output from sixth summation circuit 345 via sixth latch circuit 335. The sum output from seventh summation circuit 350 is outputted via seventh latch circuit 351 as non-linear compressed output data (y).

With the above described second core circuit 31, the points of intersection with the Y axis of the characteristic lines A, B, C, D, F and F, governing the operating characteristics shown in thick solid lines in Fig. 24, may be modified by modifying the control data (ca), (cb), (cc), (cd), (ce) and (cf) applied to second to seventh data input terminals 212 to 217, so that the operating characteristics may be optionally set variably as in the embodiment shown in Fig. 11.

When the CCD type solid state imaging device is used, as in the above described embodiment, the eight portions of the object prove to be the high luminosity image signal. Thus, when the output image signal from the solid state imaging device is subjected to the above mentioned contour compensation, the highly luminous portions are enhanced excessively to lower the image quality. For example, cross colors may be produced in a white wave surge on the beach or unnatural black fringes may be produced in the reflected sunlight on the front glass of a car under hot weather.

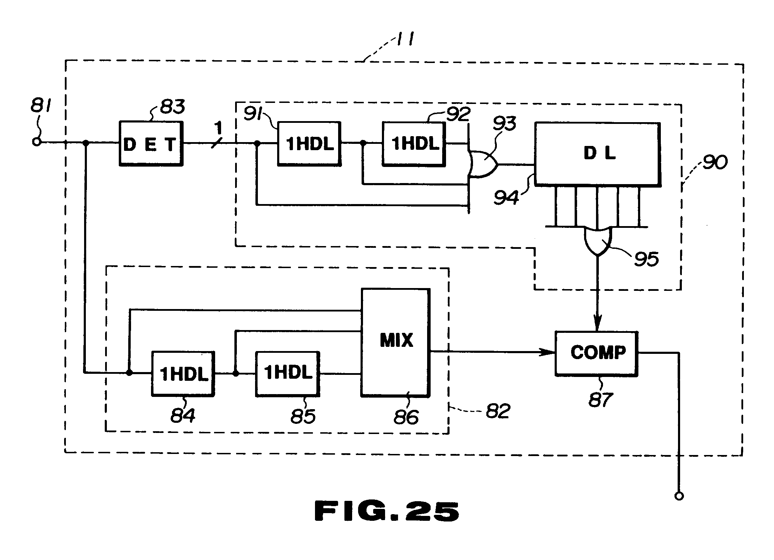

Fig. 25 shows an arrangement of a contour compensating signal forming circuit 11 for avoiding the above described deficiency.

In Fig. 25, an A/D converted digital image signal, such as digital line signal D_{G}, is supplied to an input terminal 81. This digital image signal is transmitted to a contour compensation signal forming circuit 82 and a detection circuit 83.

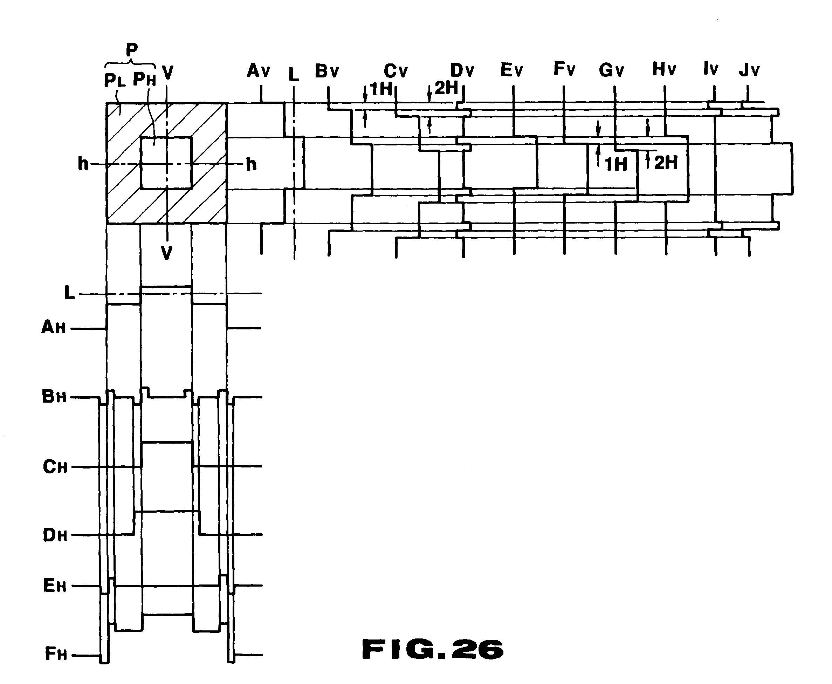

The contour compensation circuit 82 is made up of two 1H delay circuits 84 and 85 and a compensation signal forming circuit 86. The image signal from input terminal 81 is delayed by one horizontal period (1H) by 1H delay circuit 84 and further delayed by 1H by 1H delay circuit 85. It is assumed that an object P having a central portion P_{H} more luminous than a peripheral portion P_{L} as shown in Fig. 26 is imaged by a solid-state imaging device. With the attention directed to the vertical direction, shown by line v-v, signals Bv and Cv having the same waveform as and delays of 1H and 2H with respect to the input signal Av to the 1H delay circuit 84 are produced as outputs of the 1H delay circuits 84 and 85, respectively. These signals Av, Bv and Cv are transmitted to compensation signal forming circuit 86 and processed by an arithmetic operation$\text{Dv = Bv -} \frac{\text{1}}{\text{2}} \text{(Av +Cv)}$ so as to be thereby formed into a vertical contour compensation signal Dv with respect to the signal Br outputted from the 1H delay circuit 84. The compensation signal forming circuit 86 compares the adjacent data in the input image signal to detect the horizontal contour of the image to form a horizontal contour compensation signal. With the attention directed to the horizontal direction shown by line h-h of the object P shown in Fig. 26, the horizontal contour compensation signal proves to be a signal B_{H} which represents the contour extracted from the input image signal A_{H}. The so-formed contour compensation signal is supplied from contour compensation signal forming circuit 86 to compensation signal suppression circuit 87.

On the other hand, the detection circuit 83, to which the image signal from input terminal 81 is supplied, compares the value of the image signal to a predetermined value and, when the luminosity component of the image signal is higher in signal level than the predetermined value, generates a 1-bit detection signal, as an example. Now assuming that the level L shown in Fig. 26 is the above mentioned predetermined level, detection outputs shown at E_{V} and C_{H} are produced by detection circuit 83. This predetermined value prescribes the upper limit of the luminosity level for contour compensation. As a simpler method, the maximum value of the signal level of the luminosity component of the image signal supplied to input terminal 81 may be used as the predetermined value, and an overflow flag outputted from the upstream side A/D converter may be used as the detection signal.

The detection signal outputted from the detection circuit 83 is supplied to a compensation control signal generator 90. This compensation signal generator 90 is constituted by two 1H delay circuits 91, 92, a first OR circuit 93, a sample delay circuit 94 and a second OR circuit 95. The detection signal from detection circuit 93 is transmitted to 1H delay circuit 91 and thence to 1H delay circuit 92 to produce a signal Fv and a signal Gv which are delayed by LH and 2N, respectively, from the signal Ev shown in Fig. 26. These signals Ev, Fv and Gv are transmitted to OR circuit 93 where an OR is taken to generate a signal Hv indicating a time period longer by 1H each in both perpendicular directions than the time period shown by signal Fv. That is, the time interval indicated by this signal Hv is the highly luminous portion of the image signal detected by the detection circuit 83 plus the contour compensation applied to the perpendicular periphery of the high luminous portion. This signal Hv is applied from OR circuit 93 to sample delay circuit 94. This sample delay circuit 94 transmits a predetermined number of signals to the OR circuit 95, after a one-sample delay is provided to the output of the OR circuit 93. The number of samples delayed by sample delay circuit 94 corresponds to the contour compensation provided to the horizontal periphery of the high luminous portion of the image signal. Thus an output of a signal D_{H} is obtained which is the above mentioned detection signal C_{H} having its portions along both horizontal directions extended by a predetermined number of samples corresponding to the above mentioned contour compensation. That is, the compensation control signal generator 20 generates a signal indicating the high luminous portion of the image signal plus the contour compensated peripheral portion.

The output of the compensation control signal generator 90 is supplied as the compensation control signal to the compensation signal suppression circuit 87. This compensation signal suppression circuit 87 is constituted by, for example, a switch circuit while directly outputs the contour compensation signal supplied thereto from the contour compensation signal generator 83 when the compensation control signal from the compensation control signal generator 90 indicates that the level of the luminosity component of the image signal is lower than the predetermined level, and which interrupts the contour compensation signal supplied thereto from contour compensation signal generator 82 when the compensation control signal from the compensation control signal generator 90 indicates that the level of the luminosity component of the image signal is higher than the predetermined level. In this manner, the contour compensation signal is freed of contour compensation waveform corresponding to the high luminosity portion of the image signal. This compensation signal suppression circuit 87 may also be constituted by a multiplication circuit, in which a plurality of bits of the compensation control signal is applied from the compensation control signal generator 90 to suppress the contour compensation signal corresponding to the high luminous portion of the image signal to a desired number of bits.

The output from the compensation signal suppression circuit 87 is supplied to a signal synthesis circuit 14G shown in Fig. 5 so as to be combined with an image signal on the main line with temporal coincidence. In this manner, the image signal proves to be a contour compensated signal such as signal J_{V} or F_{H} shown in Fig. 26, in which contour compensation has been made only at the low luminosity component level. This contour compensated signal is transmitted to the image signal processing circuit of a succeeding stage as an output of the image signal processing circuit.

With the thus formed contour compensated signal, the portion of the contour compensated signal formed in the contour compensation signal generator 82 which is outputted from the solid-state imaging device is suppressed by the compensation control signal from the compensation signal generator 90, so that only the low luminosity portion of the image signal has been compensated for contour. By contour compensating the output analog image signal from the solid imaging device in the image signal processing circuit in this manner, an image of higher quality with proper contour compensation may be produced without excess enhancement of the high luminosity portion of the image signal.

The gamma correction circuits 15R, 15G and 15B perform gamma correction on image enhanced three-color data D_{R**}, D_{G**} and D_{B**} from the summation circuits 14R, 14G and 14B to output gamma corrected three-color data D_{R*}, D_{G*} and D_{B**}.

In this manner, the signal processing section 7 outputs image enhanced and gamma corrected 2 fs clock rate three-color data D_{R**} D_{G**} and D_{B**}. The 2 fs clock rate three color data D_{R**}, D_{G**} and D_{B**}, outputted from signal processor 7, are supplied to color encoder 8 and to digital/analog (D/A) converters 9R, 9G and 9B.

The three-color 2 fs rate high-resolution data D_{R**}, D_{G**} and D_{B**}, supplied from signal processing section 7, are converted in the D/A converters 9R, 9G and 9B into corresponding three-color output analog signals R_{OUT}, G_{OUT} and B_{OUT}, which are outputted at signal output terminals 10R, 10G and 10B, respectively.

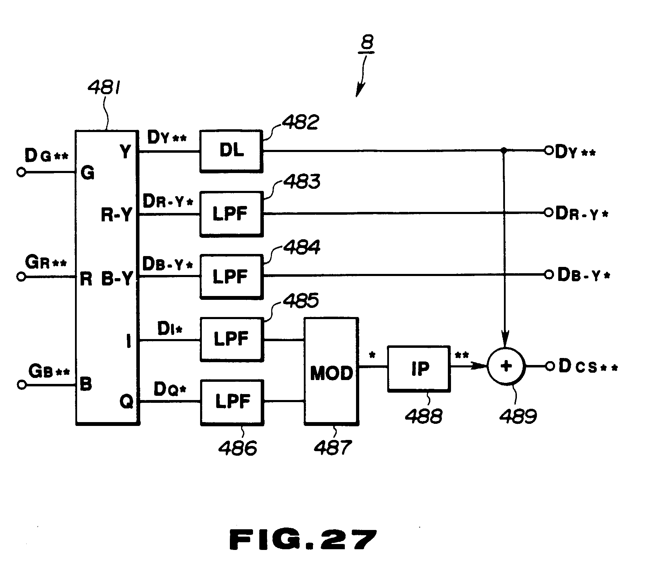

Referring to Fig. 27, the color encoder 8 is constituted by a matrix circuit 481, supplied with the 2 fs clock rate three color data D_{R**}, D_{G**} and D_{B**} from the signal processing section 7, a delay circuit 482 supplied with luminosity signal data D_{Y**} generated by the matrix circuit 481, low-pass filter 483, 484, 485, 486 supplied with color difference signal data D_{R-Y*}, D_{B-Y*}, D_{I*} and D_{Q*} formed by matrix circuit 481, a modulation circuit 487 supplied via low-pass filters 485, 486 with D_{I*}, D_{Q*} formed by matrix circuit 481, an interpolator 488 supplied with modulated output data from modulation circuit 487 and a summation circuit 489 supplied with interpolated output data from interpolator 488 and also supplied via delay circuit 482 with luminosity signal data D_{Y**} formed in matrix circuit 481.

The matrix circuit 481 performs a matrix operation on the 2 fs clock rate three-color data D_{R**}, D_{G**} and D_{B**} to form 2 fs clock rate luminosity signal data D_{Y**} and fs clock rate color difference signal data D_{R-Y*}, D_{B-Y*}, D_{I*} and D_{Q*}.

The color encoder 8 outputs the luminosity signal data D_{Y**} from matrix circuit 481 via delay circuit 482, as component color image data on the three-color data D_{R**}, D_{G**} and D_{B**}, while outputting the color difference signal data D_{R-Y*}, D_{B-Y*} from matrix circuit 481 via low-pass filters 483, 484. Meanwhile, the delay circuit 482 provides delay characteristics corresponding to the low-pass filers 483, 484 to the luminosity signal data D_{Y**.}

The modulation circuit 487 of the color encoder 8 performs an operation of two-phase d.c. modulation of the signals D_{I*} and D_{Q*} supplied from matrix circuit 481 via low-pass filers 485, 486. The modulated output data from the modulation circuit 487 corresponds to the modulated color difference signal containing odd-number order harmonics of the color subcarrier frequency fsc.

The interpolator 488 performs a digital filtering operation of extracting fsc and 7 fsc components from modulated output data from modulation circuit 487 to form modulated color difference signal data having a clock rate of 2 fs equal to 8 fsc.

The color encoder 8 sums the luminosity signal data D_{Y**}, outputted from matrix circuit 481 via delay circuit 482, to the 2 fs clock rate modulated color difference signal data, formed in the interpolator 488, to form a digital composite video signal D_{CS**}.

That is, the color encoder 8, supplied with image enhanced and gamma corrected 2 fs clock rate input three-color data D_{R**}, D_{G**} and D_{B**} from signal processing section 7, outputs component color video data composed of the 2 fs rate high resolution luminosity signal data D_{Y**} and the fs rate color difference signal data D_{R-Y*}, D_{B-Y*}, while also outputting 2 fs rate high resolution digital composite video signal D_{CS**}·

The component color image data, outputted from color encoder 8, that is the luminosity signal data D_{Y**} and the color difference signal data D_{R-Y*}, D_{B-Y*}, are supplied to digital/analog (D/A) converters 9Y, 9R-Y and 9B-Y.

The luminosity signal data D_{Y**} and the color difference signal data D_{R-Y*}, D_{B-Y*} are converted by D/A converters 9Y, 9R-Y and 9B-Y into analog component color video signals Y_{OUT}, R-Y_{OUT} and B-Y_{OUT}, which are outputted at signal output terminals 10Y, 10R-Y and 10B-Y.

The digital composite video signal D_{CS**}, outputted from color encoder 8, is supplied to digital/analog (D/A) converter 9CS, by means of which the 2 fs rate high resolution digital composite video signal D_{CS**} is converted into an analog composite video signal CS_{OUT}, which is outputted at signal output terminal 10CS.

With the above described signal processing circuit for the solid-state imaging apparatus of the present invention, the digital output signal, produced by digitizing imaging output signals read from the solid-state image sensors of the imaging section by A/D converter at a clock rate equal to the sampling rate fs, is interpolated to form a 2 fs rate signal. On the other hand, the 2 fs rate broad range horizontal detail signal is formed by detail signal generating means and summed to the 2 fs rate signal by way of performing a 2 fs rate high resolution image enhancement operation.

## Claims

1. A signal processing circuit for a solid-state color camera having first, second and third solid-state image sensors (4R, 4G, 4B) for red-color, green-color and blue-color images, respectively; said solid-state image sensor (4G) for green-color image being arrayed with a spatial pixel shift by one half of the pixel pitch with respect to said solid-state image sensors (4R, 4B) for red-color and blue-color images, said signal processing circuit comprising:
- analog/digital converting means (6R, 6B, 6G) for digitizing output signals (S_{R*}, S_{G*}, S_{B*}) read-out from said first, second and third solid-state image sensors (4R, 4B, 4G) at a clock rate equal to a sampling rate fₛ,
- first delay means (21) having one or more digital delay circuits (21a; 21b) connected in series, each digital delay circuit having a delay time of one horizontal period (1H), and said first delay means being supplied with the digitized green signal (DG*, G_{IN}) and providing a non-delayed output signal (G_{IN}) and at least one delayed output signal (G1HDL, G2HDL) with delay intervals of one horizontal period (1H) between respective ones of said output signals;
**characterized by**
- second delay means (22) having one or more digital delay circuits (22a; 22b) connected in series, each digital delay circuit having a delay time of one horizontal period (1H), and said second delay means (22) being supplied with one of digitized red and blue signals (D_{R*}, D_{B*}, R_{IN}) and providing a non-delayed output (R_{IN}) and at least one delayed output signal (R₁HDL; R₂HDL) with delay intervals of one horizontal period (1H) between respective ones of said output signals;
- first comb filter means (23) for synthesizing said plurality of output signals from said first delay means (21) such that the bandwidth of the output signals (GH, GV) thereof is limited in the vertical direction on a two-dimensional frequency space (Fig. 15);
- second comb filter means (24) for synthesizing said plurality of output signals from said second delay means (22) such that the bandwidth of the output signals (RH, RV) thereof is limited in the vertical direction on the two-dimensional frequency space (Fig. 15);
- summation means (25) summing equal amounts of the outputs of the first and second comb filter means (32, 24);
- digital filter means (26) supplied with an output (IEH') of said summation means (25) and generating a horizontal detail signal (AP, IEH) at a clock-rate 2 fs, twice the sampling rate fs; interpolating and means (13R, 13 G, 13 B) for interpolating the output signal (D_{R*}, D_{G*}, D_{B*}) of said analog/digital converting means (6R, 6G, 6B) at a clock rate equal to 2 fs, said interpolating means having the same number of orders (m) as to evenness and oddness as the number of orders (n) of the digital filter means (26) generating the horizontal detail signal so that said horizontal detail signal (AP, IEH) contains only a minor amount of unnecessary leakage components in the region of the color subcarrier frequency fsc in the two-dimensional frequency space.

2. The signal processing circuit according to claim 1, wherein further summation means (14R, 14G, 14B) are provided for summing an output signal (AP, IEH) of said digital filter means (26) to an output signal (D_{R**}, D_{G**}, D_{B**}) of said interpolating means (13R, 13G, 13B).

3. The signal processing circuit according to claim 2, further comprising gamma correction means (15R, 15G, 15B) for performing gamma correction of an output signal of said summation means (14R, 14G, 14B).

4. The signal processing circuit according to claim 2, wherein first gamma correction means (17R, 17G, 17B) are operating at a clock rate equal to fs for performing gamma correction of the output signal (D_{R*}, D_{G*}, D_{B*}) of said analog/digital converting means (6R, 6G, 6B) and are provided upstream of said interpolator (13R, 13G, 13B) and wherein second gamma correction means (18) is operating at a clock rate equal to 2 fs for performing gamma correction of said horizontal detail signal and being provided downstream of said digital filter means (26).

5. The signal processing circuit according to claim 2, wherein said interpolating means (13R, 13G, 13B) includes a digital filter having filtering characteristics with at least one zero point at the sampling rate fs.

6. The digital processing circuit according to claim 1, further comprising a non-linear operation circuit (30) supplied with the horizontal detail signal (AP, IEH) of the output of said digital filter means (26) and having characteristics of compressing the horizontal detail signals supplied thereto, wherein compression detail signals supplied thereto, compression characteristic signals on the positive side of a predetermined level and compression characteristic signals on the negative side of said predetermined level are settable independently of each other.

7. The signal processing circuit according to claim 6, wherein said non-linear operating circuit (30) has characteristics of clipping the input horizontal detail signal in the vicinity of said predetermined level at said predetermined level (Fig. 22).

8. The signal processing circuit according to claim 1, further comprising:
- vertical detail signal generating means (11) including said first and second delay means, said first and second comb filter means and said summation means,
said signal processing circuit further including a digital low-pass filter (27) supplied with an output of said vertical detail signal generating means (11) from said summation means (25) and wherein said digital filter means (26) has characteristics of passing at least a predetermined band of said signal, said summation means (25), said vertical detail signal generating means and said digital low-pass filter (27) operating at a processing rate fs equal to said sampling rate and said digital filter means (26) operating at a processing rate 2 fs, twice the sampling rate.

9. The signal processing circuit according to claim 8, wherein said digital filter means (26) has at least two even numbered zero points at the frequency fs.

10. The signal processing circuit according to claim 8, wherein said digital low-pass filter has at least two zero points in the vicinity of the color sub-carrier frequency fsc of the composite color video signal.

11. The signal processing circuit according to claim 9, wherein said digital low-pass filter has a negative response in the vicinity of the color sub-carrier frequency fsc of the composite color image signal.

12. The signal processing circuit according to claim 9, further comprising:
- detection means (83) for producing a detection signal having a duration in which the output of said analogue/digital converting means exceeds a predetermined level, compensation control signal generating means (90) for generating a compensation control signal indicating a predetermined period including the duration indicated by said detection signal from said detection means and suppressing means (87) for suppressing said horizontal and vertical detail signal during the period indicated by said compensation control signal.

## Patentansprüche

1. Signalverarbeitungsschaltung für eine Festkörper-Farbkamera mit einem ersten, zweiten und dritten Festkörper-Bildsensor (4R, 4G, 4B) für Farbbilder für rot, grün bzw. blau, wobei der Festkörper-Bildsensor (4G) für Farbbilder für grün eine Anordnung mit einer räumlichen Bildpunktverschiebung entsprechend der Hälfte der Bildpunktschrittweite in bezug auf die Festkörper-Bildsensoren (4R, 4B) für Farbbilder für rot und blau aufweist, wobei die Signalverarbeitungsschaltung folgendes aufweist:
- eine Analog/Digital-Umsetzeinrichtung (6R, 6G, 6B) zum Digitalisieren der aus dem ersten, zweiten und dritten Festkörper-Bildsensor (4R, 4B, 4G) mit einer einer Abtastrate f_{S} entsprechenden Taktrate ausgelesenen Ausgangssignale (S_{R*}, S_{G*}, S_{B*});
- eine erste Verzögerungseinrichtung (21) mit einer oder mehreren, in Reihe geschalteten digitalen Verzögerungsschaltungen (21a; 21b), von denen jede eine Verzögerungszeit einer Horizontalperiode (1H) aufweist, wobei diese erste Verzögerungseinrichtung mit dem digitalisierten Grünsignal (DG*, G_{IN}) versorgt wird und ein unverzögertes Ausgangssignal (G_{IN}) und mindestens ein verzögertes Ausgangssignal (G1HDL, G2HDL) mit Verzögerungsintervallen einer Horizontalperiode (1H) zwischen jeweiligen Ausgangssignalen aufweist;
**gekennzeichnet durch**
- eine zweite Verzögerungseinrichtung (22) mit einer oder mehreren, in Reihe geschalteten digitalen Verzögerungsschaltungen (22a; 22b), von denen jede eine Verzögerungszeit einer Horizontalperiode (1H) aufweist, wobei diese zweite Verzögerungseinrichtung (22) mit dem digitalisierten Rot- oder Blausignal (D_{R*}, D_{B*}, R_{IN}) versorgt wird und ein unverzögertes Ausgangssignal (R_{IN}) und mindestens ein verzögertes Ausgangssignal (R₁HDL; R₂HDL) mit Verzögerungsintervallen einer Horizontalperiode (1H) zwischen jeweiligen der genannten Ausgangssignale aufweist;
- eine erste Kammfiltereinrichtung (23) zum Synthetisieren der mehreren Ausgangssignale der ersten Verzögerungseinrichtung (21) in solcher Weise, dass die Bandbreite der zugehörigen Ausgangssignale (GH, GV) in der vertikalen Richtung eines zweidimensionalen Frequenzraums begrenzt ist (Fig. 15) ;
- eine zweite Kammfiltereinrichtung (24) zum Synthetisieren der mehreren Ausgangssignale der ersten Verzögerungseinrichtung (22) in solcher Weise, dass die Bandbreite der zugehörigen Ausgangssignale (RH, RV) in der vertikalen Richtung eines zweidimensionalen Frequenzraums begrenzt ist (Fig. 15);
- eine Summiereinrichtung (25) zum Summieren gleicher Werte der Ausgangssignale der ersten und der zweiten Kammfiltereinrichtung (32, 24);
- eine digitale Filtereinrichtung (26), die mit dem Ausgangssignal (IEH') der Summiereinrichtung (25) versorgt wird und ein Horizontaldetailsignal (AP, IEH) mit einer Taktrate von 2 fs erzeugt, die das Doppelte der Abtastrate fs ist; und
- eine Interpoliereinrichtung (13R, 13G, 13B) zum Interpolieren des Ausgangssignals (D_{R*}, D_{G*}, D_{B*}) der Analog/Digital-Umsetzeinrichtung (6R, 6G, 6B) mit einer 2 fs entsprechenden Taktrate, wobei diese Interpolationseinrichtung hinsichtlich gerader und ungerader ordnungen dieselbe Anzahl (m) aufweist, wie sie der Anzahl (n) von Ordnungen der das Horizontaldetailsignal erzeugenden digitalen Filtereinrichtung (26) entspricht, so dass dieses Horizontaldetailsignal (AP, IEH) nur einen untergeordneten Anteil überflüssiger Leckkomponenten im Bereich der Farbunterträgerfrequenz fsc im zweidimensionalen Frequenzraum aufweist.

2. Signalverarbeitungsschaltung nach Anspruch 1, bei der weitere Summiereinrichtungen (14R, 14G, 14B) vorhanden sind, um das Ausgangssignal (AP, IEH) der digitalen Filtereinrichtung (26) zum Ausgangssignal (D_{R**}, D_{G**}, D_{B**}) der Interpoliereinrichtung (13R, 13G, 13B) zu addieren.

3. Signalverarbeitungsschaltung nach Anspruch 2, ferner mit einer Gammakorrektureinrichtung (15R, 15G, 15B) zum Ausführen einer Gammakorrektur am Ausgangssignal der Summiereinrichtungen (14R, 14G, 14B).

4. Signalverarbeitungsschaltung nach Anspruch 2, bei der erste Gammakorrektureinrichtungen (17R, 17G, 17B) mit einer fs entsprechenden Taktrate arbeiten, um eine Gammakorrektur am Ausgangssignal (D_{R*}, D_{G*}, D_{B*}) der Analog/Digital-Umsetzeinrichtung (6R, 6G, 6B) auszuführen, wobei sie stromabwärts bezüglich der Interpolationseinrichtung (13R, 13G, 13B) angeordnet sind, und bei der eine zweite Gammakorrektureinrichtung (18) mit einer 2 fs entsprechenden Taktrate arbeitet, um eine Gammakorrektur des Horizontaldetailsignals auszuführen, wobei sie stromabwärts bezüglich der digitalen Filtereinrichtung (26) angeordnet ist.

5. Signalverarbeitungsschaltung nach Anspruch 2, bei der die Interpolationseinrichtung (13R, 13G, 13B) ein digitales Filter mit einer Filtercharakteristik mit mindestens einem Nullpunkt bei der Abtastrate fs enthält.

6. Digitale Verarbeitungsschaltung nach Anspruch 1, ferner mit einer nichtlinearen Funktionsschaltung (30), die mit dem Horizontaldetailsignal (AP, IEH) am Ausgang der digitalen Filtereinrichtung (26) versorgt wird und die Eigenschaft einer Kompression der ihr zugeführten Horizontaldetailsignale aufweist, wobei ihr zugeführte Horizontaldetailsignale, Kompressionscharakteristiksignale auf der positiven Seite eines vorbestimmten Pegels und Kompressionscharakteristiksignale auf der negativen Seite dieses vorbestimmten Pegels unabhängig voneinander einstellbar sind.

7. Signalverarbeitungsschaltung nach Anspruch 6, bei der die nichtlineare Funktionsschaltung (30) die Eigenschaft des Beschneidens des eingegebenen Horizontaldetailsignals in der Nähe des vorbestimmten Pegels auf diesen vorbestimmten Pegel hat (Fig. 22).

8. Signalverarbeitungsschaltung nach Anspruch 1, ferner mit:
- einer Vertikaldetailsignal-Erzeugungseinrichtung (11) mit einer ersten und einer zweiten Verzögerungseinrichtung, der ersten und zweiten Kammfiltereinrichtung und der Summiereinrichtung;
- wobei die Signalverarbeitungsschaltung ferner ein digitales Tiefpassfilter (27) aufweist, die mit dem Ausgangssignal der Vertikaldetailsignal-Erzeugungseinrichtung (11) von der Summiereinrichtung (25) versorgt wird, wobei die digitale Filtereinrichtung (26) die Eigenschaft aufweist, dass sie zumindest ein vorbestimmtes Band des Signals durchlässt, und wobei die Summiereinrichtung (25), die Vertikaldetailsignal-Erzeugungseinrichtung und das digitale Tiefpassfilter (27) bei einer der Abtastrate entsprechenden Verarbeitungsrate fs arbeiten und die digitale Filtereinrichtung (27) bei einer Verarbeitungsrate 2 fs arbeitet, die das Doppelte der Abtastrate ist.

9. Signalverarbeitungsschaltung nach Anspruch 8, bei der die digitale Filtereinrichtung (26) mindestens zwei gerade Nullstellen bei der Frequenz fs aufweist.

10. Signalverarbeitungsschaltung nach Anspruch 8, bei der das digitale Tiefpassfilter in der Nähe der Farbunterträgerfrequenz fsc des zusammengesetzten Farbvideosignals mindestens zwei Nullstellen aufweist.

11. Signalverarbeitungsschaltung nach Anspruch 9, bei der das digitale Tiefpassfilter in der Nähe der Farbunterträgerfrequenz fsc des zusammengesetzten Farbbildsignals negatives Ansprechverhalten aufweist.

12. Signalverarbeitungsschaltung nach Anspruch 9, ferner mit
- einer Erfassungseinrichtung (83) zum Erzeugen eines Erfassungssignals mit einer Dauer, während der das Ausgangssignal der Analog/Digital-Umsetzeinrichtung einen vorbestimmten Pegel überschreitet;
- einer Kompensationssteuersignal-Erzeugungseinrichtung (90) zum Erzeugen eines Kompensationssteuersignals, das eine vorbestimmte Periode einschließlich der durch das Erfassungssignal von der Erfassungseinrichtung angezeigten Dauer anzeigt; und
- einer Unterdrückungseinrichtung (87) zum Unterdrücken des Horizontal- und Vertikaldetailsignals während der durch das Kompensationssteuersignal angegebenen Periode.

## Revendications

1. Circuit de traitement de signal pour une caméra couleur à l'état solide ayant des premier, second et troisième capteurs d'image à l'état solide (4R, 4G, 4B) pour des images de couleur rouge, de couleur verte et de couleur bleue , respectivement; ledit capteur d'image à l'état solide (4G) pour des images de couleur verte étant disposé avec un décalage spatial de pixel d'un demi pas de pixel par rapport auxdits capteurs d'image à l'état solide (4R, 4B) pour des images de couleur rouge et de couleur bleue, ledit circuit de traitement de signal comprenant :
- un moyen de conversion analogique/numérique (6R, 6B, 6G) pour numériser des signaux de sortie (S_{R*}, S_{G*}, S_{B*}) extraits desdits premier, second et troisième capteurs d'image à l'état solide (4R, 4B, 4G) à une fréquence d'horloge égale à une fréquence d'échantillonnage fs ;
- un premier moyen à retard (21) ayant un ou plusieurs circuits à retard numériques (21a ; 21b) montés en série, chaque circuit à retard numérique ayant un retard d'une période horizontale (1H), et ledit premier moyen à retard recevant le signal vert numérisé (DG*, G_{IN}) et fournissant un signal de sortie non retardé (G_{IN}) et au moins un signal de sortie retardé (G1HDL, G2HDL) avec des intervalles de retard d'une période horizontale (1H) entre ceux des signaux de sortie stables respectifs;
caractérisé par
un second moyen à retard (22) ayant un ou plusieurs circuits à retard numériques (22a ; 22b) montés en série, chaque circuit à retard numérique ayant un retard d'une période horizontale (1H), et ledit second moyen à retard (22) recevant un des signaux numérisés de rouge et de bleu (D_{R*}, D_{B*}, R_{IN}) et fournissant une sortie non retardée (R_{IN}) et au moins un signal de sortie retardée (R₁HDL ; R₂HDL) avec des intervalles de retard d'une période horizontale (1H) entre ceux desdits signaux de sortie respectifs ;
- un premier moyen de filtre en peigne (23) pour synthétiser ladite pluralité de signaux de sortie dudit premier moyen à retard (21) pour que la largeur de bande des signaux de sortie (GH, GV) de celui-ci soit limitée dans la direction verticale sur un espace de fréquence bidimensionnel (figure 15) ;
- un second moyen de filtre en peigne (24) pour synthétiser ladite pluralité de signaux de sortie dudit second moyen à retard (22) pour que la largeur de bande des signaux de sortie (RH, RV) de celui-ci soit limitée dans la direction verticale sur un espace de fréquence bidimensionnel (figure 15) ;
- un moyen de sommation (25) additionnant des quantités égales de sortie des premier et second moyens de filtre en peigne (32, 24) ;
- un moyen de filtre numérique (26) recevant une sortie (IEH') dudit moyen de sommation (25) et pour générer un signal de détail horizontal (AP, IEH) à une fréquence d'horloge de 2 fs, double de la fréquence d'échantillonnage fs, et un moyen d'interpolation (13R, 13G, 13B) pour interpoler le signal de sortie (D_{R*}, D_{G*}, D_{B*}) dudit moyen de conversion analogique/numérique (6R, 6G, 6B) à une fréquence d'horloge égale à 2 fs, ledit moyen d'interpolation ayant le même nombre d'ordres (m) quant à l'imparité et à la parité que le nombre d'ordres (n) du moyen de filtre numérique (26) générant le signal de détail horizontal, pour que ledit signal de détail horizontal (AP, IEH) ne contiennent qu'une quantité mineure de composantes de fuite inutile dans la zone de la fréquence de sous-porteuse de couleur fsc dans l'espace de fréquence bidimensionnel.

2. Circuit de traitement de signal selon la revendication 1, dans lequel d'autres moyens de sommation (14R, 14G, 14B) sont fournis pour additionner un signal de sortie (AP, IEH) dudit moyen de filtre numérique (26) à un signal de sortie (D_{R**}, D_{G**}, D_{B**}) dudit moyen d'interpolation (13R, 13G, 13B).

3. Circuit de traitement de signal selon la revendication 2, comprenant en outre un moyen de correction de gamma (15R, 15G, 15B) pour réaliser une correction de gamma d'un signal de sortie dudit moyen de sommation (14R, 14G, 14B).

4. Circuit de traitement de signal selon la revendication 2, dans lequel des premiers moyens de correction de gamma (17R, 17G, 17B) fonctionnent à une fréquence d'horloge égale à fs pour une réaliser une correction de gamma du signal de sortie (D_{R*}, D_{G*}, D_{B*}) dudit moyen de conversion analogique/numérique (6R, 6G, 6B) et sont placés en amont dudit interpolateur (13R, 13G, 13B) et dans lequel un second moyen de correction de gamma (18) fonctionne à une fréquence d'horloge égale à 2 fs pour réaliser une correction de gamma dudit signal de détail horizontal et étant placés en aval dudit moyen de filtre numérique (26).

5. Circuit de traitement de signal selon la revendication 2, dans lequel ledit moyen d'interpolation (13R, 13G, 13B) comprend un filtre numérique ayant des caractéristiques de filtrage avec au moins un point nul à la fréquence d'échantillonnage fs.

6. Circuit de traitement de signal selon la revendication 1, comprenant en outre un circuit de fonctionnement non-linéaire (30) recevant le signal de détail horizontal (AP, IEH) de la sortie dudit moyen de filtre numérique (26) et ayant des caractéristiques de compression des signaux de détail horizontaux reçus sur celui-ci, dans lequel des signaux de détail de compression fournis à celui-ci, des signaux de caractéristique de compression du côté positif d'un niveau prédéterminé et des signaux de caractéristique de compression du côté négatif dudit niveau prédéterminé sont réglables indépendamment les uns des autres.

7. Circuit de traitement de signal selon la revendication 6, dans lequel ledit circuit de fonctionnement non-linéaire (30) a des caractéristiques d'écrêtage du signal de détail horizontal d'entrée au voisinage dudit niveau prédéterminé audit niveau prédéterminé (figure 22).

8. Circuit de traitement de signal selon la revendication 1, comprenant en outre :
- un moyen de génération de signal de détail vertical (11) comprenant lesdits premier et second moyens à retard, lesdits premier et second moyens de filtre en peigne et lesdits moyens de sommation,
ledit circuit de traitement de signal comprenant en outre un filtre passe-bas numérique (27) recevant une sortie dudit moyen de génération de signal de détail vertical (11) dudit moyen de sommation (25) et dans lequel, ledit moyen de filtre numérique (26) a des caractéristiques de passage d'au moins une bande prédéterminée dudit signal, ledit moyen de sommation (25), ledit moyen de génération de signal de détail vertical et ledit filtre passe-bas numérique (27) fonctionnant à une fréquence de traitement fs égale à ladite fréquence d'échantillonnage et ledit moyen de filtre numérique (26) fonctionnant à une fréquence de traitement 2 fs, double de la fréquence d'échantillonnage.

9. Circuit de traitement de signal selon la revendication 8, dans lequel ledit moyen de filtre numérique (26) a au moins deux points nuls de nombre pair à la fréquence fs.

10. Circuit de traitement de signal selon la revendication 8, dans lequel ledit filtre passe-bas numérique a au moins deux points nuls au voisinage de la fréquence de sous-porteuse de couleur fsc du signal vidéo de couleur composite.

11. Circuit de traitement de signal selon la revendication 9, dans lequel ledit filtre passe-bas numérique a une réponse négative au voisinage de la fréquence de sous-porteuse de couleur fsc du signal d'image de couleur composite.

12. Circuit de traitement de signal selon la revendication 9 comprenant en outre :
- un moyen de détection (83) pour produire un signal de détection ayant une durée dans laquelle la sortie dudit moyen de conversion analogique/numérique dépasse un niveau prédéterminé, un moyen de génération de signal de commande de compensation (90) pour générer un signal de commande de compensation indiquant une période prédéterminée comprenant la durée indiquée par ledit signal de détection dudit moyen de détection et un moyen de suppression (87) pour supprimer ledit signal de détail horizontal et vertical pendant la période indiquée par ledit signal de commande de compensation.
